# EUROPEAN PATENT APPLICATION

(11) **EP 4 665 108 A1**
(43) Date of publication of application: **17.12.2025**
(21) Application number: 25165703.7
(22) Date of filing: 24.03.2025
(51) Int. Cl.: H10B 41/27, H10B 41/50, H10B 43/27, H10B 43/50, H01L 23/522, H01L 23/528

(54) **SEMICONDUCTOR DEVICES AND DATA STORAGE SYSTEMS INCLUDING THE SAME**

(30) Priority: 11.06.2024 KR 20240075838
(71) Applicant: Samsung Electronics Co., Ltd., Suwon-si, Gyeonggi-do 16677 (KR)
(72) Inventor: PARK, Joowon, 16677 Suwon-si (KR); YU, Jonghun, 16677 Suwon-si (KR); JEONG, Kilsu, 16677 Suwon-si (KR); JEONG, Jonghyeon, 16677 Suwon-si (KR); KIM, Dongwon, 16677 Suwon-si (KR); LEE, Changsup, 16677 Suwon-si (KR)
(74) Representative: Marks & Clerk LLP

(57) **Abstract**

A semiconductor device includes a conductive layer; stack structures including gate electrodes stacked in a first direction, and the stack structures stacked in the first direction in a first region and a second region neighboring the first region; a channel structure penetrating the stack structures in the first direction; contact structures including a first portion penetrating the stack structures, and a second portion extending from the first portion to a different length, penetrating a gate electrodes and in contact with a gate electrode, the first portion including one sub-part penetrating one of the stack structures, a width of an upper surface of the sub-part is greater than a width of a lower surface, and the sub-part includes an inclined side surface between an upper surface and a lower surface, and widths of a lower surface of the first portion and an upper surface of the second portion are the same.

## Description

### BACKGROUND

Example embodiments of the present disclosure relate to semiconductor devices and data storage systems including the same.

It may be advantageous for a semiconductor device to store high-capacity data in a data storage system requiring data storage. Accordingly, a method for increasing data storage capacity of semiconductor devices has been researched. For example, as a method for increasing data storage capacity of semiconductor devices, semiconductor devices including memory cells disposed three-dimensionally, instead of memory cells disposed two-dimensionally, has been suggested.

### SUMMARY

Some example embodiments of the present disclosure provide a semiconductor device having improved reliability by reducing an etching depth for a contact plug in a channel structure having a relatively long length and high integration density while simplifying a manufacturing process.

Some example embodiments of the present disclosure provide a data storage system including a semiconductor device having improved reliability by reducing an etching depth for a contact plug in a channel structure having a relatively long length and/or high integration density while simplifying a manufacturing process.

According to some example embodiments of the present disclosure, a semiconductor device may include a conductive layer; a plurality of stack structures, each stack structure of the plurality of stack structures including a plurality of gate electrodes stacked in order in a first direction perpendicular to an upper surface of the conductive layer, the plurality of stack structures stacked in order in the first direction in a first region and in a second region neighboring the first region; a channel structure including a plurality of channel portions penetrating the plurality of stack structures, respectively and the plurality of channel portions connected to each other in the first direction in the first region; a plurality of first-type contact structures penetrating at least one of the gate electrodes of an uppermost stack structure among the plurality of stack structures, the plurality of first-type contact structures extending to different lengths and electrically connected to the gate electrodes of the uppermost stack structure, respectively, in the second region; a plurality of second-type contact structures completely penetrating at least one of the plurality of stack structures from an upper portion of the uppermost stack structure, the plurality of second-type contact structures extending to different lengths, and electrically connected to uppermost gate electrodes of the stack structures below the uppermost stack structure, respectively, in the second region; and a plurality of third-type contact structures, each third-type contact structure including a first portion completely penetrating at least one of the plurality of stack structures from the upper portion of the uppermost stack structure, and a second portion extending from a lower portion of the first portion to a different length, penetrating at least one of the gate electrodes and electrically connected to an allocated gate electrode in the second region, wherein a boundary surface between the first portion and the second portion of each of the third-type contact structures is at a same level as a boundary surface between the plurality of channel portions of the channel structure.

According to some example embodiments of the present disclosure, a semiconductor device may include a conductive layer; a plurality of stack structures, each stack structure of the plurality of stack structures including gate electrodes stacked in order in a first direction perpendicular to an upper surface of the conductive layer, the plurality of stack structures stacked in order in the first direction in a first region and a second region neighboring the first region; a channel structure penetrating the plurality of stack structures and extending in the first direction in the first region; and contact structures each including a first portion completely penetrating at least one of the plurality of stack structures from an upper portion of an uppermost stack structure, and a second portion extending from a lower portion of the first portion to a different length, penetrating at least one of the gate electrodes and in contact with an allocated gate electrode, wherein the first portion includes at least one sub-part completely penetrating one of the stack structures, a width of an upper surface each of the at least one sub-part is greater than a width of a lower surface of the at least one sub-part, and the at least one sub-part includes a continuously inclined side surface between the upper surface and the lower surface, and widths of a lower surface of the first portion and an upper surface of the second portion are the same.

According to some example embodiments of the present disclosure, a data storage system may include a semiconductor storage device including a first semiconductor structure including circuit elements, a second semiconductor structure on one surface of the first semiconductor structure, an input/output pad electrically connected to the circuit elements; and a controller electrically connected to the semiconductor storage device through the input/output pad and controlling the semiconductor storage device, wherein the second semiconductor structure includes, a conductive layer; a plurality of stack structures, each stack structure of the plurality of stack structures including gate electrodes stacked in order in a first direction perpendicular to an upper surface of the conductive layer, the plurality of stack structures stacked in order in the first direction in a first region and a second region neighboring the first region; a channel structure penetrating the plurality of stack structures and extending in the first direction in the first region; and contact structures including a first portion completely penetrating at least one stack structure of the plurality of stack structures from an upper portion of an uppermost stack structure, and a second portion extending from a lower portion of the first portion to a different length, penetrating at least one of the gate electrodes and in contact with an allocated gate electrode in the second region, wherein the first portion includes at least one sub-part completely penetrating one of the stack structures, a width of an upper surface of each of the at least one sub-part is greater than a width of a lower surface of the at least one sub-part, and the at least one sub-part includes an inclined side surface between the upper surface and the lower surface continuously, and widths of a lower surface of the first portion and an upper surface of the second portion are the same.

At least some of the above and other features of the invention are set out in the claims.

### BRIEF DESCRIPTION OF DRAWINGS

The above and other aspects, features, and/or advantages of the present disclosure will be more clearly understood from the following detailed description, taken in combination with the accompanying drawings, in which:
FIG. 1 is a plan diagram illustrating a semiconductor device according to some example embodiments of the present disclosure;
FIGS. 2A to 2D are cross-sectional diagrams illustrating a semiconductor device according to some example embodiments of the present disclosure;
FIGS. 3A to 3D are enlarged diagrams a partial region illustrated in FIGS. 4A to 3C;
FIGS. 4 and 7 are cross-sectional diagrams illustrating a semiconductor device according to some example embodiments of the present disclosure;
FIGS. 8 to 11 are cross-sectional diagrams illustrating a semiconductor device according to some example embodiments of the present disclosure;
FIG. 12 is a diagram illustrating a diagram illustrating an etching process for forming a contact hole in a semiconductor device according to some example embodiments of the present disclosure;
FIGS. 13A to 13L are cross-sectional diagrams illustrating a method of manufacturing a semiconductor device;
FIG. 14 is a diagram illustrating a data storage system including a semiconductor device according to some example embodiments of the present disclosure; and
FIG. 15 is a perspective diagram illustrating a data storage system including a semiconductor device according to some example embodiments of the present disclosure.

### DETAILED DESCRIPTION

Hereinafter, some example embodiments of the present disclosure will be described as follows with reference to the accompanying drawings.

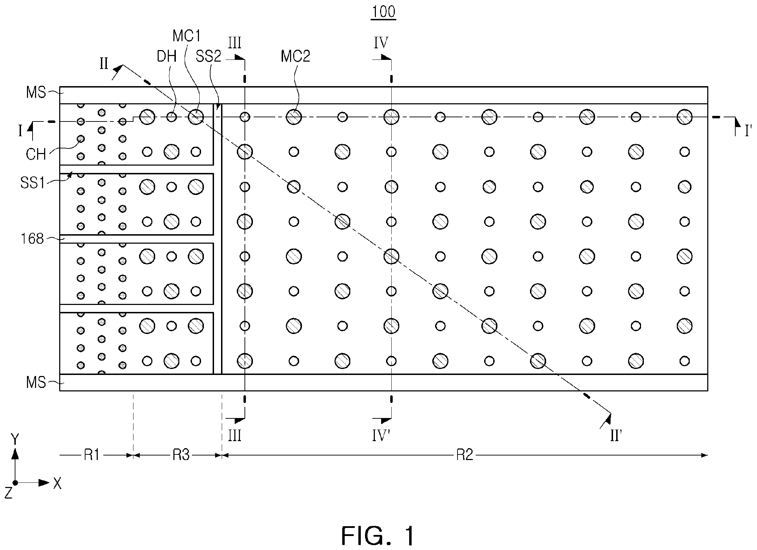

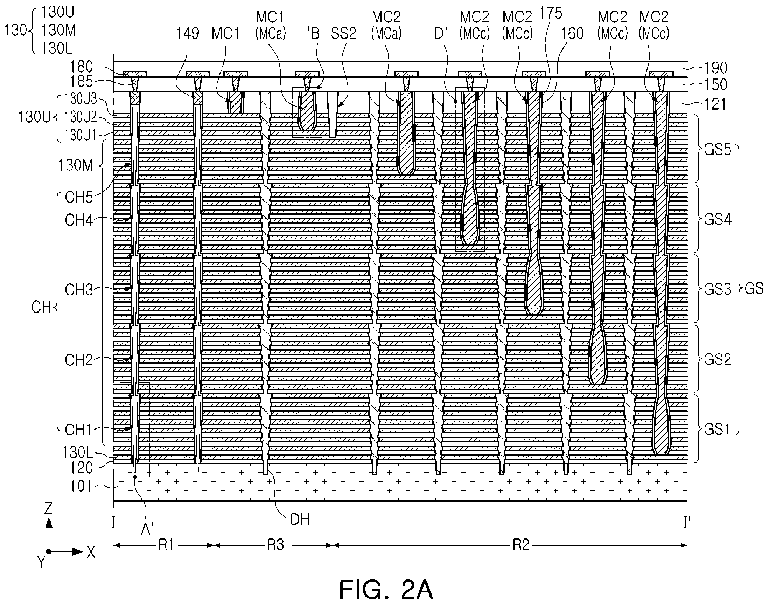

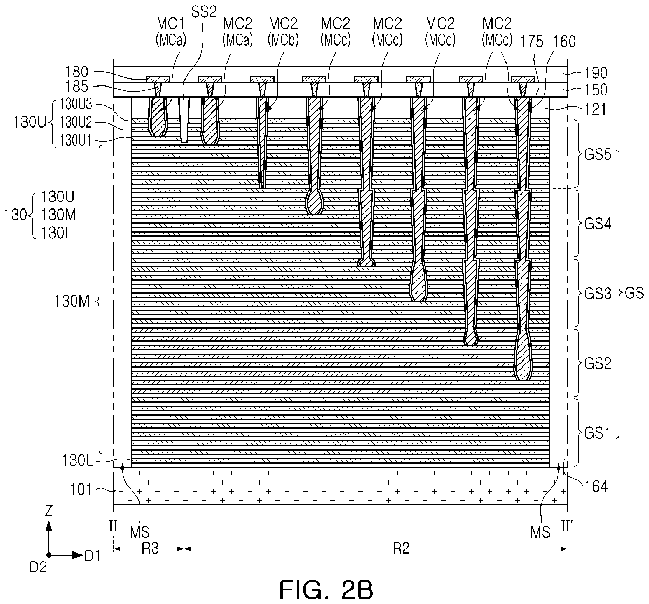

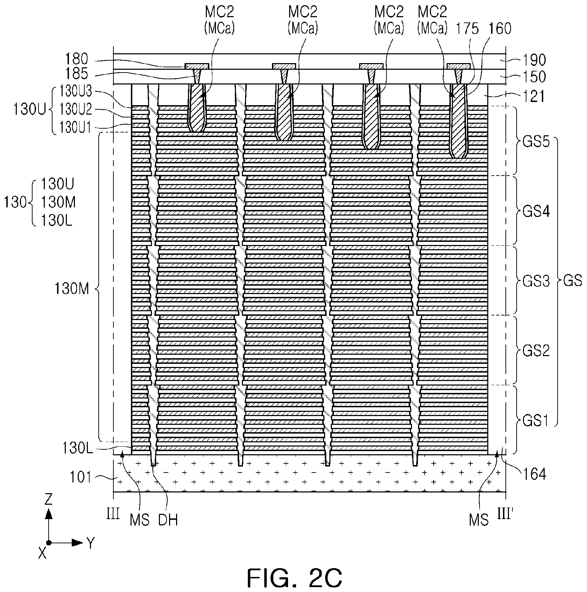

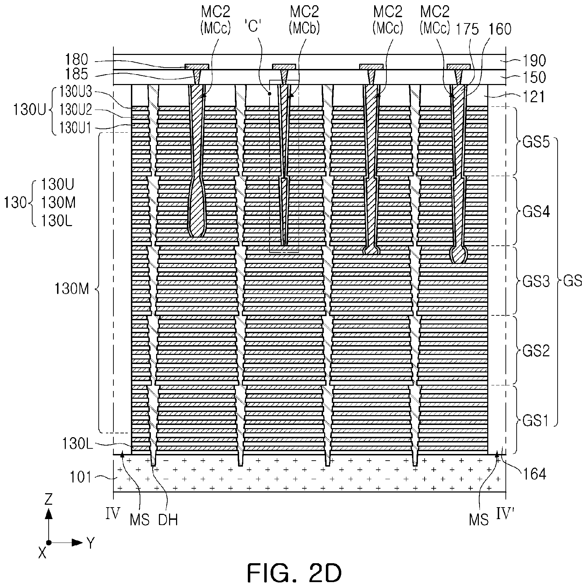

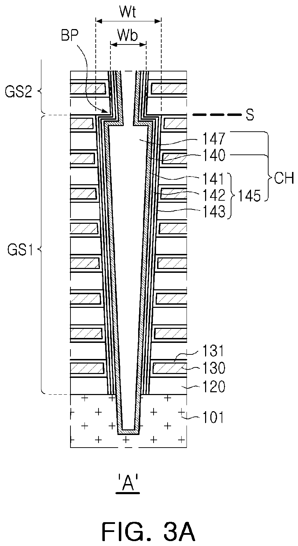

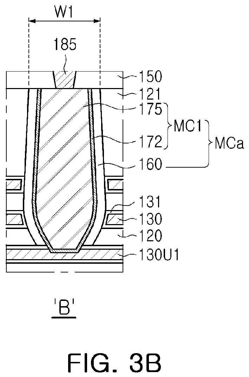

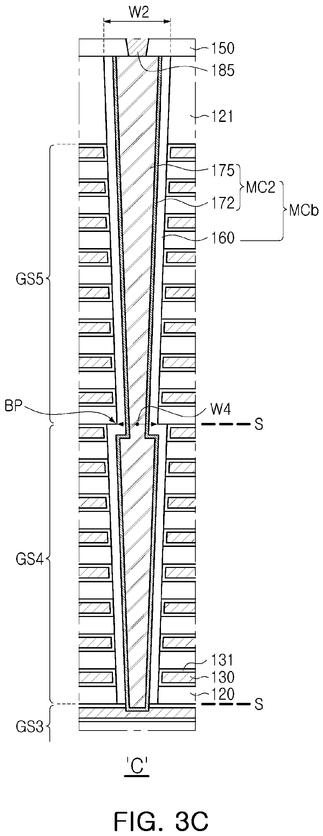

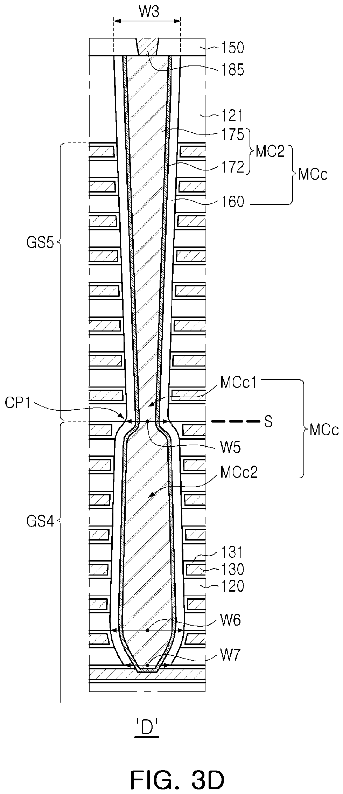

FIG. 1 is a plan diagram illustrating a semiconductor device according to some example embodiments. FIGS. 2A to 2D are cross-sectional diagrams illustrating a semiconductor device according to some example embodiments. FIG. 2A is a cross-sectional diagram illustrating a region of the semiconductor device in FIG. 1 taken along line I-I'. FIG. 2B is a cross-sectional diagram illustrating a region of the semiconductor device in FIG. 1 taken along line II-II'. FIG. 2C is a cross-sectional diagram illustrating a region of the semiconductor device in FIG. 1 taken along line III-III'. FIG. 2D is a cross-sectional diagram illustrating a region of the semiconductor device in FIG. 1 taken along line IV-IV'. FIG. 3A is an enlarged diagram illustrating region "A" in FIG. 2A, FIG. 3B is an enlarged diagram illustrating region "B" in FIG. 2A, FIG. 3C is an enlarged diagram illustrating region "C" in FIG. 2D, and FIG. 3D is an enlarged diagram illustrating region "D" in FIG. 2A.

The structure of the semiconductor device will be explained with reference to a first direction (an X-direction), a second direction (a Y-direction) and a third direction (a Z-direction). The first direction may cross (e.g. may be perpendicular to) the second direction. The first direction and second direction may cross (e.g. may be perpendicular to) the third direction. The first direction and second direction may be parallel to an upper surface of a conductive layer of the semiconductor device. The third direction may be perpendicular to the upper surface of the conductive layer of the semiconductor device. The third direction may define a vertical direction (e.g. a height direction). Features that are described as "above" other features may be located further along the third direction than the other features. Upper features may be located above lower features. It will be appreciated that the directions are defined relative to the structure of the semiconductor device, and need not imply any particular orientation of the semiconductor device in use.

Referring to FIGS. 1 to 3D, the semiconductor device 100 may include a memory region R1 and an extension region R2 in the X-direction to one side of the memory region R1.

The memory region R1 may be a memory cell region in which memory cell strings CSTR are disposed, and channel structures CH may be disposed in the memory region R1. The extension region R2 may be configured to electrically connect the channel structures CH to peripheral circuit structures, and to this end, a plurality of wordline contact plugs MC2 connected to the gate electrodes 130 at different levels may be disposed in the extension region R2, but some example embodiments thereof are not limited thereto. The memory region R1 may be defined as each mat when a plurality of mats are disposed, but some example embodiments thereof are not limited thereto.

A string select region R3 may be disposed between the memory region R1 and the extension region R2. The string select region R3 may be defined as a region in which string select contact plugs MC1 are disposed to select each of the gate electrodes 130, which are string select lines.

The semiconductor device 100 may have a structure in which the memory region R1, the string select region R3, and the extension region R2 are disposed in succession in the X-direction. By isolating the gate electrodes 130, the memory region R1 and the string select region R3 may be defined as a first region, and the extension region R2 may be defined as a second region.

The semiconductor device 100 may include a conductive layer 101 in the memory region R1, the string select region R3, the extension region R2, stack structures GS (GS1-GSk, k is 1, 2, 3..., a positive integer) in which the gate electrodes 130 and the interlayer insulating layers 120 are alternately stacked on an upper surface of the conductive layer 101, channel structures CH disposed in the memory region R1 to penetrate the stack structures GS1-GSk, isolation regions MS penetrating the stack structures GS1-GSk and extending in the X-direction, and insulating regions SS penetrating a portion of the gate electrodes 130. An interconnection structure and a passivation layer may further be included in a lower portion of the conductive layer 101.

Support structures DH and wordline contact plugs MC2 may be disposed in the extension region R2, and the support structures DH and the string select contact plugs MC1 may be disposed in the string select region R3.

In FIGS. 2A to 3D, the contact plugs MC1 and MC2 may extend by different lengths for connection between each gate electrode 130 and the contact plugs MC1 and MC2, but some example embodiments thereof are not limited thereto.

The memory region R1 and the extension region R2 may include a cell region insulating layer 150 as an upper portion of the stack structure GS1-GSk, studs 185 penetrating the cell region insulating layer 150 and provided for electrical connection with the channel structure CH and the contact plugs MC1 and MC2, and an upper interconnection structure 180 in an upper portion of the cell region insulating layer 150.

The conductive layer 101 may include at least one of a conductive material such as doped silicon and a conductive material such as a metal or a metal nitride as a common source line. For example, the conductive layer 101 may include a silicon layer having an N-type conductivity, which may be a common source.

The gate electrodes 130 may be vertically stacked on an upper surface of the conductive layer 101 and may form a stack structure GS (GS1-GSk) together with interlayer insulating layers 120. The gate electrodes 130 may extend from the extension region R2 to the memory region R1 on one side, but the gate electrodes 130U of the upper portion may be physically and electrically isolated between the string select region R3 and the extension region R2.

The stack structure GS1-GSk may include stack structures GS1-GSk having a plurality of stages and vertically stacked. In FIGS. 2A to 3D, first to fifth stack structures GS1, GS2, GS3, GS4, and GS5 are included, but some example embodiments thereof are not limited thereto, and stack structures GS1-GS6, GS1-GS8 having six to eight stages may be included. In some example embodiments, the stack structure GS1-GSk may include two stack structures GS1-GS2. That is, the number of stack structures may be any number greater than or equal to two.

The stages of the stack structures GS1-GSk may be classified by heights of stack structures in which a process of forming a channel hole having a predetermined or alternatively desired depth in the channel structure CH is performed, and may be classified by channel portions of the channel structure CH.

The lower stack structure disposed on an upper surface of the conductive layer 101 may be referred to as the first stack structure GS1, the stack structures GS2-GSk on the first stack structure GS1 may be referred to as the second stack structure GS2, the third stack structure GS3, and the fourth stack structure GS4 to the kth stack structure (GSk, k=5) in order, and each of the second to fifth stack structures GS2-GS5 may be referred to as an upper stack structure. Also, the kth stack structure (GSk, k=5) disposed in an uppermost region and disposed furthest from the conductive layer 101 in the Z-direction may be referred to as an uppermost stack structure.

In the stack structures GS1-GSk, the gate electrodes 130 and the interlayer insulating layers 120 may be alternately stacked in the Z-direction, and the boundary surface S between the stack structures GS1-GSk may be defined as an interfacial surface of the uppermost gate electrode 130 of the stack structures GS1-GS4 disposed in a lower portion and the lowermost interlayer insulating layer 120 of the stack structures GS2-GS5 disposed in an upper portion. A boundary surface S may be provided at the interface between each adjacent stack structure. Thicknesses of the lowermost interlayer insulating layer 120 and the uppermost gate electrode 130 disposed at the boundary surface S may be substantially the same as thicknesses of the other interlayer insulating layer 120 and the gate electrode 130. The length in the Z-direction of each of the stack structures GS1-GS5 and the number of the gate electrodes 130 may be substantially the same, but some example embodiments thereof are not limited thereto.

With respect to the entire stack structures GS1-GS5, the gate electrodes 130 may include at least one lower gate electrode 130L forming a gate of a ground select transistor, memory gate electrodes 130M forming a plurality of memory cells, and upper gate electrodes 130U forming a string select line of gates of string select transistors. Here, the lower gate electrode 130L and the upper gate electrodes 130U may be referred to as "lower" and "upper" with respect to the direction during the manufacturing process. The number of memory gate electrodes 130M forming the memory cells may be determined depending on capacity of the semiconductor device 100. In some example embodiments, the number of each of the upper and lower gate electrodes 130U and 130L may be 1 to 2 or more, and may have a structure the same as or different from a structure of the memory gate electrodes 130M. In some example embodiments, the number of upper gate electrodes 130U may be three. The erase gate electrodes 130 may be disposed further below the upper gate electrodes 130U. Also, a portion of the gate electrodes 130, for example, the memory gate electrodes 130M adjacent to the upper or lower gate electrode 130U and 130L, may be dummy gate electrodes 130, but some example embodiments thereof are not limited thereto.

Referring to FIGS. 1 to 2D, the gate electrodes 130 may be isolated from each other in the Y-direction by the isolation regions MS extending continuously from the memory region R1 to the extension region R2. The gate electrodes 130 between a pair of isolation regions MS may form a memory block BLK, but some example embodiments of the memory block BLK are not limited thereto. A portion of the gate electrodes 130, for example, the memory gate electrodes 130M, may form a layer within the memory block BLK.

The gate electrodes 130 may be stacked vertically within the memory region R1, the string select region R3, and the extension region R2, and may maintain a continuous plate shape without forming a step structure of a staircase shape within the extension region R2. A contact region of each of the gate electrode 130 may be defined as a region in contact with the contact plugs MC1 and MC2 within the string select region R3 and the extension region R2.

The gate electrodes 130 may be formed of, for example, W, Ru, Mo, Nb, Ni, Co, Ti, Ta, TiN, TaN, WN, NbN, TiAl, TiAlN, TiSi, TiSiN, TaSi, TaSiN, RuTiN, NiSi, CoSi, or a combination thereof, but some example embodiments thereof are not limited thereto. In some example embodiments, the gate electrodes 130 may further include a diffusion barrier 131, for example, the diffusion barrier 131 may include tungsten nitride (WN), tantalum nitride (TaN), titanium nitride (TiN), or a combination thereof.

The interlayer insulating layers 120 may be disposed between the gate electrodes 130 and may form stack structures GS1, GS2, GS3, GS4, and GS5. The interlayer insulating layers 120 may also be stacked in a direction (e.g. the Z-direction) perpendicular to an upper surface of the conductive layer 101 and may extend in the X-direction, similarly to the gate electrodes 130. The interlayer insulating layers 120 may include an insulating material, such as silicon oxide or silicon nitride.

In some example embodiments, thicknesses of the interlayer insulating layers 120 may be substantially the same, but thicknesses of a portion thereof may not be the same. For example, an uppermost interlayer insulating layer 121 among the interlayer insulating layers 120 may have a thickness greater than a thickness of the other interlayer insulating layers 120, but some example embodiments thereof are not limited thereto.

The isolation regions MS may be disposed to penetrate at least a portion of the gate electrodes 130 and to extend in the X-direction. The isolation regions MS may cross the memory region R1, the string select region R3, and the extension region R2 in succession and may extend in the X-direction. The isolation regions MS may penetrate the entire stacked gate electrodes 130 and may be connected to the conductive layer 101. The isolation regions MS may extend in the X-direction as an integrated region, or may extend intermittently in a portion thereof, or may be disposed only in a portion of regions. The isolation regions MS may have a line shape on an X-Y plane, or may have a shape in which a side surface has a continuous curved surface and extends in the X-direction.

The isolation regions MS may have an isolation insulating layer 164 disposed therein. The isolation insulating layer 164 may have a shape of which a width decreases toward the conductive layer 101 due to a high aspect ratio, but some example embodiments thereof are not limited thereto. An upper surface of the isolation insulating layer 164 may be in contact with the cell region insulating layer 150, and a lower surface may be in contact with an upper surface of the conductive layer 101.

The insulating regions SS may include first insulating regions SS1 extending in the X-direction and second insulating regions SS2 extending in the Y-direction between adjacent isolation regions MS. The insulating regions SS may selectively penetrate only the upper gate electrodes 130U1-130U3, that is, the string select lines SSL, and may divide the upper gate electrodes 130U1-130U3 among the stack structures GS1-GS5 into a plurality of sub-regions.

Referring to FIG. 1, the second insulating regions SS2 may cross the extension region R2 and the string select region R3 in the Y-direction and may isolate the upper gate electrodes 130U1-130U3. When at least three upper gate electrodes 130U1-130U3 are allocated to the string select line, the three upper gate electrodes 130U1-130U3 may be simultaneously penetrated by the second insulating regions SS2 and may be physically/electrically spaced apart from each other on a plane.

The first insulating regions SS1 may extend across the memory region R1 and the string select region R3 in the X-direction. The first insulating regions SS1 may include a plurality of first insulating regions SS1 parallel to each other between the isolation regions MS and stacked (e.g. separated from each other) in the Y-direction, and may selectively isolate only the upper gate electrodes 130U1-130U3, such as the second insulating regions SS2.

The first insulating regions SS1 and the second insulating regions SS2 may be disposed to have the same length in the Z-direction (e.g., depth) from the upper portion, and the lower surface may be disposed at a level lower than a level of a lower surface of the lowermost upper gate electrode 130U1 among the upper gate electrodes 130U1-130U3, and may be disposed at a level higher than a level of a lower surface of the interlayer insulating layer 120 below (e.g. immediately below) the lowermost upper gate electrode 130U1. Accordingly, the first insulating regions SS1 and the second insulating regions SS2 may completely penetrate the entirety of the upper gate electrodes 130U1-130U3, such that the upper gate electrodes 130U1-130U3 may form a plurality of sub-regions physically/electrically completely separated.

The insulating regions SS1 and SS2 may not be disposed within the extension region R2, and may isolate the extension region R2 and the string select region R3. The upper gate electrodes 130U1-130U3 may be isolated as a plurality of sub-regions in the Y-direction within the memory region R1 and the string select region R3, may not be isolated within the extension region R2 and may form a single plate shape. In this case, the insulating regions SS1 and SS2 may selectively penetrate only the upper gate electrodes 130U1-130U3, and may not extend below the memory gate electrode 130M, such that the memory gate electrodes 130M and the lower gate electrodes 130L may not be isolated from each other by the insulating regions SS1 and SS2, and may be stacked in a plate shape up to the memory region R1, the string select region R3, and the extension region R2.

An end of the first insulating regions SS1 may cross the second insulating region SS2 and may extend into the extension region R2, but some example embodiments thereof are not limited thereto, and the first insulating regions SS1 may be connected to the second insulating region SS2.

The first insulating regions SS1 may be disposed across a portion of the channel structures CH within the memory region R1. The first insulating regions SS1 may have a predetermined or alternatively desired width in the Y-direction and may extend across a plurality of channel structures CH arranged in a zigzag pattern in the X-direction. Accordingly, when the plurality of channel structures CH are arranged to have the same spacing distance, the first insulating regions SS1 may extend across a row of channel structures CH simultaneously. The first insulating regions SS1 may be recessed into an upper portion of the channel structures CH, for example, an upper end of the channel structures CH facing three upper gate electrodes 130U, and accordingly, a portion of the channel structures CH may be removed. In this case, the channel structures CH may be recessed by a length smaller than a radius of the channel structure CH from the channel central axis to an internal wall of the channel hole. Accordingly, the first insulating regions SS1 may be disposed such that the channel structure CH may not pass through the channel central axis of the channel structure CH and more than half of the channel structure CH may remain on the upper surface, but some example embodiments thereof are not limited thereto. The channel structures CH into which the first insulating regions SS1 are recessed may be effective channel structures actually functioning as memory cells, rather than dummy channel structures. Each of the insulating regions SS1 and SS2 may include an upper isolation insulating layer 168. The upper isolation insulating layer 168 may include an insulating material, for example, silicon oxide, silicon nitride, or silicon oxynitride.

The channel structures CH may be stacked on the conductive layer 101 of the memory region R1 while forming rows and columns. In the memory region R1, the channel structures CH may be disposed in a zigzag pattern in one direction on the X-Y plane. The channel structures CH may penetrate the gate electrodes 130, may extend in a vertical direction perpendicular to an upper surface of the conductive layer 101, for example, in the Z-direction, may have a pillar shape, and may have an inclined side surface of which a width decreases toward the conductive layer 101 depending on an aspect ratio. The width of the channel structures CH may be measured in a direction perpendicular to the Z-direction (e.g. the X-direction and/or the Y-direction).

Each of channel structures CH may have a form in which a k number of channel portions CH1-CHk (k is a positive integer, such as 1, 2, 3, 4, ...) are connected to each other, each penetrating the k number of stack structures GS1-GSk of the gate electrodes 130, and in some example embodiments, five first to fifth channel portions CH1-CH5, penetrating five stack structures GS1-GS5, respectively, may be connected to each other. The connection portion between the first to fifth channel portions CH1-CH5 may have a bent portion BP due to a difference or a change in width.

As illustrated in the enlarged diagram in FIG. 3A, an upper end of each of the first to fifth channel portions CH1-CH5 may have a width Wt greater than a width Wb of a lower end, and due to a width difference between the upper end and the lower end, the side surface may have a slope of which a width may decrease toward the conductive layer 101. The lower ends of the channel portion CH1-CH5 in the upper portion (e.g. an upper channel portion) and the upper ends of the channel portion CH1-CH5 in the lower portion (e.g. a lower channel portion) may be connected to each other and may form a bent portion BP. That is, between adjacent channel portions in the Z-direction there may be provided a bent portion BP. Each pair of adjacent channel portions may comprise an upper channel portion that is located immediately above a corresponding lower channel portion, wherein the lower end of the upper channel portion is connected to the upper end of the lower channel portion via the corresponding bent portion BP. The bent portions BP may be disposed on the boundary surfaces S of the first to fifth stack structures GS1-GS5, and the upper surface of each of the first to fifth channel portions CH1-CH5 may be coplanar with the upper surface of a corresponding one of the first to fifth stack structures GS1-GS5, and when viewed in the cross-section, the side surface of the channel structure CH may be bent along the boundary surface S at a lower end along a slope of the side surface of each of the channel portions CH1-CH5, and may form a bent portion BP extending to an upper end of the channel portion CH1-CH5 in the lower portion, and the bent portion BP may have a discontinuous shape having a corner.

Each of the channel structures CH may include a first portion within the stack structures GS1-GS5 and a second portion protruding below the stack structures GS1-GS5 and in contact with the conductive layer 101.

The channel layer 140 may be disposed entirely on the first portion and the second portion of the channel structures CH, and may be disposed up to an upper end of the second portion. The second portion of the channel structures CH may be disposed below the stack structures GS1-GS5, and the channel layer 140 may include a protrusion protruding and exposed below the stack structures GS1-GS5, and a non-protrusion disposed in the first portion of the channel structure CH. The lengths of the protrusions of the second portions in the channel structures CH and the protrusions of the channel layer 140 may not be the same, but some example embodiments thereof are not limited thereto. The channel layer 140 may be formed to have an annular shape of which a side surface thereof surrounds a buried insulating layer 147 therein, but in some example embodiments, the channel layer 140 may have a columnar shape, such as a cylinder or a prism, without the buried insulating layer 147. The protrusion of the channel layer 140 may extend into the conductive layer 101 and may be in contact, for example direct contact, with the conductive layer 101. The protrusion may be formed to have a non-protrusion and a gentle slope such that the annular shape may be maintained as in FIG. 3A. The channel layer 140 may include a semiconductor material, such as polycrystalline silicon or single crystal silicon, and the semiconductor material may be an undoped material or a material including P-type or N-type impurities.

In the channel structures CH, channel pads 149 may be disposed in an upper portion of the channel layer 140. The channel pads 149 may be disposed to cover an upper surface of a buried insulating layer 147 and may be electrically connected to the channel layer 140. The channel pads 149 may include, for example, doped polycrystalline silicon.

A channel dielectric layer 145 may be disposed between the gate electrodes 130 and the channel layer 140. The channel dielectric layer 145 may include a tunneling layer 141, a charge storage layer 142, and a blocking layer 143 stacked in order from the channel layer 140. The tunneling layer 141 may tunnel charge into the charge storage layer 142 and may include, for example, silicon oxide (SiO₂), silicon nitride (Si₃N₄), silicon oxynitride (SiON), or combinations thereof. The charge storage layer 142 may be a charge trap layer or a floating gate conductive layer. The blocking layer 143 may include silicon oxide (SiO₂), silicon nitride (Si₃N₄), silicon oxynitride (SiON), a high-k dielectric material, or combinations thereof. According to some example embodiments, at least a portion of the channel dielectric layer 145 may form a channel dielectric layer extending horizontally along the gate electrodes 130.

The channel dielectric layer 145 may be removed from a region below the stack structures GS1-GS5 in the second portion such that the protrusion of the channel layer 140 may be exposed externally. Accordingly, the lower end of the channel dielectric layer 145 may be in contact with the conductive layer 101, and the side surface of the channel dielectric layer 145 may be disposed to surround the non-protrusion of the channel layer 140 in the first portion.

The channel layer 140, the channel dielectric layer 145, and the buried insulating layer 147 may be connected to each other between the first to fifth channel portions CH1-CH5.

The support structures DH may be disposed in the string select region R3 and the extension region R2, and may have a structure the same as or similar to the channel structures CH, and may not perform an actual function within the semiconductor device 100. The support structures DH may be disposed regularly in columns and rows in the string select region R3 and the extension region R2. The support structures DH may have a diameter the same as or greater than a diameter, for example a maximum diameter, of the channel structures CH and a diameter the same as or less than a diameter, for example a maximum diameter, of the contact plugs MC1 and MC2. The shapes of the support structures DH, the numbers of the support structures DH and/or spacings therebetween may be different. The channel structures CH and the support structures DH may have a circular shape or an almost circular shape, but some example embodiments thereof are not limited thereto, and the channel structures CH and the support structures DH may have an oval shape. The support structures DH may penetrate the stack structures GS1-GS5 similarly to the channel structures CH and may include a vertical portion extending in the Y-direction and horizontal portions protruding from the vertical portion toward each of the gate electrodes 130, but some example embodiments thereof are not limited thereto. The support structure DH may also have a structure including a plurality of bent portions corresponding to the bent portion BP of the first to fifth channel portions CH1-CH5 of the channel structures CH. The support structures DH may be supports which may prevent or reduce in likelihood deformation such as warpage of the stack structures GS 1-GS5.

The semiconductor device 100 may include contact plugs MC1 and MC2 connected to the gate electrodes 130, respectively, in the string select region R3 and the extension region R2. The contact plugs MC1 and MC2 may penetrate at least a portion of the uppermost interlayer insulating layer 121, may extend downwardly in the Z-direction and may be connected to an upper surface of the allocated gate electrodes 130. The contact plugs MC1 and MC2 may have a circular shape or an elliptical shape on the X-Y plane as illustrated in FIG. 1 and may be stacked in the X-direction and Y-direction. The contact plugs MC1 and MC2 may be arranged in a lattice shape or a zigzag pattern.

Each of the contact plugs MC1 and MC2 may include a plug conductive layer 175 and a contact barrier layer 172 surrounding a side surface and a lower surface of the plug conductive layer 175, and a side insulating layer 160 may be further disposed on the side surface of the contact barrier layer 172 of the contact plugs MC1 and MC2. The contact plugs MC1 and MC2 and the side insulating layer 160 surrounding the side surfaces of the contact plugs MC1 and MC2 may be referred to as contact structures MCa, MCb, and MCc.

In each of the contact plugs MC1 and MC2, a lower surface of the contact barrier layer 172 may be connected to and in contact with a contact region of one of the gate electrodes 130, and the side insulating layer 160 may electrically insulate the gate electrodes 130 and the plug conductive layer 175 adjacent to a side surface of the plug conductive layer 175. The plug conductive layer 175 may extend continuously from the contact region of the gate electrode 130 to upper surfaces of the contact plugs MC1, MC2 in contact with lower surfaces of the contact plugs MC1, MC2.

In some example embodiments, each end of the stack structures GS1-GS5 may include eight gate electrodes 130, and at least one contact plug MC1, MC2 in physical/electrical contact with each gate electrode 130 may be disposed. The number of gate electrodes 130 in the first to fifth stack structures GS1-GS5 may be an example, but some example embodiments thereof are not limited thereto.

The contact plugs MC1, MC2 may include string contact plugs MC1 and wordline contact plugs MC2.

The string contact plugs MC1 may be disposed in the string select region R3, and may be connected to a predetermined or alternatively desired number of upper gate electrodes 130U1-130U3 of the upper portion functioning as string select lines among the upper gate electrodes 130U, respectively.

FIGS. 1 to 2B illustrate that three string select lines are included, and accordingly, three string select contact plugs MC1 connected to the upper gate electrodes 130U1-130U3, which are string select lines, may be disposed in each sub-region. That is, the string select contact plugs MC1 connected to the string select lines may be disposed in the sub-regions of the upper gate electrodes 130U divided by the first and second insulating regions SS1 and SS2. In some example embodiments, each of the upper gate electrodes 130U1-130U3 may be connected to a string select contact plug MC1, or alternatively, a plurality of string select contact plugs MC1 may be connected to one of the upper gate electrode 130U1-130U3. Accordingly, the number of string select contact plugs MC1 allocated to each of the sub-regions may be the same, and the number of string select contact plugs MC1 allocated to each of the sub-regions may satisfy an integer multiple of the number of gate electrodes functioning as string select lines.

In each sub-region, the first to third upper gate electrodes 130U1-130U3 may be individually connected to each other by three string select contact plugs MC1, may transmit electrical signals and may select the channel structure CH of the corresponding sub-regions.

The string select contact plugs MC1 may not protrude externally of the sub-regions of the first to third upper gate electrodes 130U1-130U3, the lower end of the first string select contact plug MC1 may be in contact, for example direct contact, with an upper surface of the uppermost upper gate electrode 130U3. A lower end of the second string select contact plug MC1 may be in contact, for example direct contact, with an upper surface of the upper gate electrode 130U2. Thereafter upper gate electrode 130U2, and a lower end of the third string select contact plug MC1 may be in contact, for example direct contact, with an upper surface of the third upper gate electrode 130U1. Accordingly, the string select contact plugs MC1 may not extend externally of each sub-region formed by cutting off three first to third upper gate electrodes 130U1-130U3, that is, the string select contact plugs MC1 may not extend below the third upper gate electrode 130U1.

In the extension region R2, when the wordline contact plugs MC2, connected to memory gate electrodes 130M and lower gate electrodes 130L, respectively, are allocated one by one, the wordline contact plugs MC2 may be disposed to have different lengths to be connected to the gate electrodes 130M, 130L having different levels.

In some example embodiments in FIGS. 2A to 3D, the first to fifth stack structures GS1-GS5 may include gate electrodes 130 of eight stages, and since three gate electrodes 130U of the upper portion function as string select lines, 37 gate electrodes 130M, 130L may remain. The wordline contact plugs MC2 of which lengths are adjusted differently to be in contact with the upper surfaces of the 37 gate electrodes 130M and 130L, respectively, may be disposed in the extension region R2.

The arrangement of the wordline contact plugs MC2 may be varied, and in some example embodiments, as illustrated in FIG. 1, the wordline contact plugs MC2 may be arranged such that the wordline contact plugs MC2 may be lowered by one layer at a time in the Z-direction toward the Y-direction in column 1, and each may be in contact with the allocated gate electrodes 130, respectively. Accordingly, as illustrated in FIG. 2C, the wordline contact plugs MC2 arranged in the Y-direction may have a length increasing in the Z-direction such that the wordline contact plugs MC2 may be in contact with the fourth to seventh gate electrodes 130, respectively, when the uppermost gate electrode 130 is referred to as the first gate electrode 130U3. In column 2, the wordline contact plugs MC2 may extend to be in contact with each of the 8th gate electrode 130 to the 11th gate electrode 130, and in column 3, the wordline contact plugs MC2 may extend to be in contact with each of the 12th gate electrode 130 to the 15th gate electrode 130. Also, as illustrated in FIG. 2D, a length in the Z-direction of the wordline contact plugs MC2 arranged in the Y-direction may increase to be in contact with the 16th gate electrode 130 to the 19th gate electrode 130 in column 4, respectively. Accordingly, the wordline contact plugs MC2 may be arranged to have a length increasing in a direction away from the memory region R1 in the X-direction, and the wordline contact plugs MC2 may be arranged to have a length downwardly in the Y-direction, but some example embodiments thereof are not limited thereto. For example, the wordline contact plugs MC2 may be arranged in a single row, and may also be arranged symmetrically such that the length may increase toward a center. The wordline contact plugs MC2 disposed in the last column may include dummy wordline contact plugs MC2, and may function as a support structure DH without performing the function of selecting actual wordline.

In the contact structures MCa, MCb, and MCc, the side insulating layer 160 may be disposed only on the side surfaces of the contact plugs MC1, MC2 such that the contact region of the gate electrode 130 and the lower surface of the contact barrier layer 172 may be in contact, for example direct contact, with each other, and in some example embodiments, a portion of the contact plugs MC1, MC2 may be disposed to extend to a level lower than the upper surface of the allocated gate electrode 130, and may not extend to a level lower than a level of the lower surface of the allocated gate electrode 130. Accordingly, the lower surface of the contact plugs MC1, MC2 may be disposed at a level the same as or lower than an upper surface of the gate electrode 130 in contact with the contact plugs, and at a level higher than a level of the lower surface.

The plug conductive layer 175 of the contact structures MCa, MCb, and MCc may include a conductive material, for example, at least one of tungsten (W), copper (Cu), aluminum (Al), and an alloy thereof. For example, the plug conductive layer 175 may include tungsten (W). The contact barrier layer 172 may include tungsten nitride (WN), tantalum nitride (TaN), titanium nitride (TiN), or a combination thereof.

The side insulating layers 160 may include an insulating material, for example, silicon oxide, silicon nitride, or silicon oxynitride.

The contact structures MCa, MCb, and MCc may have different shapes depending on the shapes of the contact plugs MC1 and MC2 included therein. The contact structures MCa, MCb, and MCc may have different lengths and different shapes to be in contact with the gate electrodes 130 disposed at different levels, respectively.

Specifically, the contact structures MCa, MCb, and MCc may include first-type contact structures MCa (e.g. first contact structures), second-type contact structures MCb (e.g. second contact structures), and third-type contact structures MCc (e.g. third contact structures). The classification of contact structures MCa, MCb, and MCc may be based on their shapes rather than based on the type of contact plugs (string select contact plug, wordline contact plug). Each of the first-type contact structures MCa, the second-type contact structures MCb, and the third-type contact structures MCc may have a symmetrical structure based on a conceptual line passing through a center of a width (e.g., a maximum width) of the upper surface (of the contact structure), but some example embodiments thereof are not limited thereto. That is, each of the first-type contact structures MCa, the second-type contact structures MCb, and the third-type contact structures MCc may be symmetrical about a corresponding central axis of symmetry. The width of the contact structures may be measured in a direction perpendicular to the Z-direction (e.g. the X-direction and/or the Y-direction).

However, the contact structures including the string select contact plugs MC1 in contact with the uppermost gate electrode 130U3 may not be structures penetrating the gate electrodes 130, and may only penetrate the uppermost interlayer insulating layer 121. Accordingly, the contact structures in contact with the uppermost gate electrode 130U3 may include string select contact plugs MC1 having a plug shape and a side insulating layer 160 surrounding a side surface thereof, and may have a structure in which a width of an upper surface may be greater than a width of a lower surface and an inclined side surface may be formed between the upper surface and the lower surface.

The first-type contact structures MCa may be contact structures MCa to be in contact with the gate electrodes 130 in the uppermost stack structure GS5 other than the uppermost gate electrode 130U3, and may be contact structures MCa including a portion of the string select contact plugs MC1 to the wordline contact plugs MC2 connected to the eighth gate electrode 130.

Referring to FIGS. 2A, 2B, 2C and 3B, the first-type contact structures MCa may have a continuous side surface from an upper surface to a lower surface, wherein the upper surface is coplanar with the upper surface of the uppermost interlayer insulating layer 121, and a width thereof may increase toward the lower surface. The first-type contact structures MCa may include a reduction portion of which a width may decrease inwardly from a portion close to the lower surface, but some example embodiments thereof are not limited thereto, and the first-type contact structures MCa may be disposed such that the lower surface thereof may have the greatest width. For example, the first-type contact structures MCa may have a greatest width at the portion between the upper surface and the lower surface at which the width decreases inwardly toward the lower surface. For example, the first-type contact structures MCa may have a greatest width at the portion close to the lower surface at which the width decreases inwardly toward the lower surface. The first-type contact structures MCa may not include a bent portion BP of which a width may decrease from the upper surface to the lower surface and may increase, and the width may uniformly increase. Accordingly, the first-type contact structures MCa may have a first-type contact structure MCa (as illustrated in FIG. 2A) including a wordline contact plug MC2 in contact with the lowermost gate electrode 130 within the uppermost stack structure GS5 having the longest length.

The upper surface of the first-type contact structures MCa may have a first width W1, and the first width W1 may be greater than a width, for example a maximum width, of the support structure DH.

The second-type contact structures MCb may be contact structures MCb to be in contact with the uppermost gate electrodes 130 in each of the stack structures GS1-GS4, other than the uppermost stack structure GS5. When each of the stack structures GS1-GS4 includes eight gate electrodes 130, the second-type contact structures MCb may be contact structures MCb including word line contact plugs MC2 connected to the 9th, 17th, 25th, and 3rd gate electrodes 130 from the upper portion of the uppermost stack structure GS5, respectively.

Referring to FIGS. 2B, 2D, and 3C, the second-type contact structures MCb may include a side surface having a slope in which a width decreases from an upper surface to a lower surface, the upper surface being coplanar with an upper surface of the uppermost interlayer insulating layer 121. An upper surface of the second-type contact structure MCb may be disposed on the same level as an upper surface of the uppermost interlayer insulating layer 121. The second-type contact structure MCb may completely penetrate the stack structures GS2-GS5 from the upper surface to the upper surface of the allocated gate electrode 130, and may extend in the Z-direction. The length of the second-type contact structure MCb may be determined according to the number of stack structures GS penetrated by the second-type contact structure MCb. The second-type contact structure MCb in contact with the 9th gate electrode 130 may have a length equal to the sum of lengths of the uppermost stack structure GS5 from the upper surface of the uppermost interlayer insulating layer 121. The second-type contact structure MCb in contact with the 17th gate electrode 130 may have a length equal to a length of a sum of a sub-part having a length equal to the sum of lengths of the uppermost stack structure GS5 from an upper surface of the uppermost interlayer insulating layer 121 and a sub-part having the same length as a length of the stack structure GS4 below an uppermost portion. Each sub-part penetrating each of the stack structures GS2-GS5 may have a side surface having a continuous slope such that the second width W2 of the upper surface may be greater than a width W4 of the lower surface, and the side surfaces may have a continuous slope such that a width may decrease towards the lower surface. In this case, when the second-type contact structure MCb includes a plurality of sub-parts, the bent portion BP may be formed by a difference between a second width W2 of the upper surface and a width W4 of the lower surface, and the bent portion BP may be disposed at the same level as the bent portion BP of the channel structure CH at the boundary surface S between the stack structures GS1-GS4. That is, each sub-part having a shape in which the second width W2 of the upper surface is greater than the width W4 of the lower surface may be disposed for each of the stack structures GS2-GS5, may be connected to each other in the Z-direction and may form a second-type contact structure MCb. The width W4 of the lower surface of a sub-part may be the width of the second-type contact structure MCb at the level of the boundary surface S at the bottom of that sub-part. In this context, a "lower surface" of a sub-part between two sub-parts may be a bottom of the sub-part (a boundary between sub-parts), but may not be a physical surface (for instance, there may not be any physical break in the plug conductive layer 170, the contact barrier layer 172 or the side insulating layer 160. The same applies to an upper portion between two sub-parts. Instead, the upper/lower surface may be defined as a boundary at the level of the break portion BP between two sub-parts.

Accordingly, the second-type contact structure MCb connected to the 9th gate electrode 130 may include a sub-part penetrating only the fifth stack structure GS5 without a bent portion BP, and the second-type contact structure MCb connected to the 17th gate electrode 130 may include a bent portion BP according to a difference in widths W2 and W4 between the upper surface and the lower surface of each sub-part on the boundary surface S between the fifth stack structure GS5 and the fourth stack structure GS4 as illustrated in FIG. 3C. The bent portion BP may be connected to and in contact with a sub-part of the upper portion of the second-type contact structure MCb and a sub-part of the lower portion, similarly to the channel structure CH, and may be implemented by discontinuous aspects having corners.

The second-type contact structures MCb may have upper surfaces having the same width W2 regardless of lengths thereof. In this case, the second width W2 of the upper surface of the second-type contact structures MCb may be smaller than the first width W1 of the upper surface of the first-type contact structures MCa.

The third-type contact structure MCc may include the other contact structures MCc other the second-type contact structures MCb among the contact structures MCb and MCc to be in contact with gate electrodes 130 in the stack structures GS 1-GS4 other than the uppermost stack structure GS5.

Referring to FIG. 2A, FIG. 2B, FIG. 2D and FIG. 3D, the third-type contact structures MCc may have a structure in which the second-type contact structures MCb and the first-type contact structures MCa are coupled to each other.

The third-type contact structure MCc may have a length longer than a length of one of the stack structures GS1-GS5. In the case in which at least one stack structures GS2-GS5 is disposed above the allocated gate electrode 130, the first portion MCc1 corresponding to a length of at least one stack structures GS2-GS5 completely penetrated by the third-type contact structure MCc may be included, and a second portion MCc2 extending from the lower surface of the first portion MCc1 and extending to a level at which the gate electrode 130 allocated below the first portion MCc1 is disposed.

The shape of the first portion MCc1 may be similar to or correspond to the second-type contact structures MCb, and the shape of the second portion MCc2 may be similar to or correspond to the first-type contact structures MCa. In this case, the configuration in which the components are similar to or correspond to each other may indicate that the components may be the same as each other, and may also indicate that the shapes of the components may be similar, and the direction in which the width increases may be similar.

Referring to FIG. 2A and FIG. 3D, the gate electrode 130 allocated to be in contact with the third-type contact structure MCc among the k number of the stack structures GS1-GSk may be disposed within the mth stack structure (GSm, m<k, m=1, 2,...k-1). In this case, in the first portion MCc1 of the third-type contact structure MCc penetrating the k-m stack structures GS from the upper portion, sub-parts having a width decreasing from the upper surface to the lower surface, similarly to the second-type contact structure MCb, may be disposed in each stage of the stack structure GSm+1-GSk on the mth stack structure GSm, and may have a bent portion BP on the boundary surfaces S between the stack structures GSm+1-GSk on the mth stack structure GSm.

As an example, as illustrated in FIG. 2A and FIG. 3D, when the gate electrode 130 in contact with the third-type contact structure MCc is disposed in the third stack structure GS3 from the upper portion, in the first portion MCc1 of the third-type contact structure MCc penetrating two stack structures GS4, GS5 from the upper portion, two sub-parts of which a width decreases from the upper surface to the lower surface, such as the second-type contact structure MCb, may be disposed in order in the stack structures GS4 and GS5, and may have a bent portion BP in the boundary surface S of the stack structures GS4 and GS5.

The bent portion BP may be disposed such that an upper surface of the lower portion may be parallel to the upper surface of the stack structure GS4 of the lower portion, such that the side surface may indicate a discontinuous side surface having a corner, and each bent portion BP may be disposed at the same level as one of the bent portions BP of the channel structure CH.

The second portion MCc2 may be disposed such that the second portion may extend from the lower surface of the first portion MCc1 to a region below the first portion MCc1 to the upper surface of the allocated gate electrode 130.

The second portion MCc2 may have a shape similar to the first-type contact structure MCa, and may include a reduction portion of which a width may increase from the upper surface to the lower surface and then may decrease toward the lower surface, but some example embodiments thereof are not limited thereto. The width, for example a maximum width, W6 of the second portion MCc2 may be disposed within a range of the thickness of the penetrating lowermost gate electrode 130, but an example some embodiments thereof are not limited thereto. That is, the second portion MCc2 may include a reduction portion of which a width increases toward the lower portion and then decreases while penetrating the corresponding gate electrode 130, and the width W7 of the lower surface may have a value smaller than the width, for example the maximum width, W6. However, even when the width W7 of the lower surface of the second portion MCc2 decreases due to the reduction portion, the value may be the same as or greater than the width W5 of the lower surface of the first portion MCc1.

The boundary between the first portion MCc1 and the second portion MCc2 may include the curved portion CP in the boundary surface S of the stack structures GS1-GS5. Differently from the bent portion BP, the curved portion CP may not have a corner, and the lower surface of the first portion MCc1 and the upper surface of the second portion MCc2 may coincide with each other, such that the first portion MCc1 and the second portion MCc2 may continuously form a curved surface and the slope may change.

As illustrated in FIG. 3D, the third-type contact structures MCc in the stack structure GS4 of the second stage from the upper portion of the stack structure GS may include only the curved portion CP without the bent portion BP, and the third-type contact structure MCc in contact with the gate electrode 130 in the stack structure GS3-GS1 below the third stage may include both the bent portion BP and the curved portion CP. Depending on the level of the gate electrode 130 in contact with, a plurality of bent portions BP may be included together with the curved portion CP.

Accordingly, the third-type contact structures MCc may include third-type contact structures MCc in which first portions MCc1 may have different lengths including different numbers of sub-parts, and second portions MCc2 may have the same length. Accordingly, the second portions MCc2 (e.g. within one row) may be in contact with gate electrodes 130 at the same level from the upper portion within the stack structures GS in each stage.

When the first portion MCc1 includes a plurality of sub-parts, the widths W3 of the upper surfaces of the portions may be the same. The upper surface of the third-type contact structures MCc may have a third width W3, and the third width W3 may have a width greater than the width, for example the maximum width, of the support structure DH and may be the same as or greater than the first width W1 of the first-type contact structures MCa.

Accordingly, among the contact structures MCa, MCb, and MCc, the second width W2 of the upper surface of the second-type contact structure MCb may be the smallest, and the third width W3 of the third-type contact structure MCc may be the same as or greater than the first width W1 of the first-type contact structure MCa.

In the contact structures MCa, MCb, and MCc, the second-type and third-type contact structures MCb and MCc extending by penetrating the stack structures GS having a plurality of stages may have bent portions BP at the same level as the bent portion BP of the channel structure CH, which may be exhibited by forming contact holes of the second-type and third-type contact structures MCb and MCc together up to the boundary surface S between stages of the stack structure GS when the channel hole of the channel structure CH is formed.

In the string select region R3 and the extension region R2, the support structures DH may be arranged to have a regular pattern with the contact structures MCa, MCb, and MCc peripherals. For example, as illustrated in FIG. 1, the support structures DH and the contact structures MCa, MCb, and MCc may be disposed alternately, but some example embodiments thereof are not limited thereto.

The cell region insulating layer 150 may be disposed to cover the stack structure GS. In some example embodiments, the cell region insulating layer 150 may include a plurality of insulating layers. The cell region insulating layer 150 may be formed of an insulating material, and may include, for example, at least one of silicon oxide, silicon nitride, and/or silicon oxynitride.

Studs 185 and cell interconnection lines 180 may form a cell interconnection structure electrically connected to memory cells. The studs 185 may penetrate a portion of the cell region insulating layer 150 and may be connected to the channel structures CH and the contact structures MCa, MCb, and/or MCc, and may be electrically connected to the channel layers 140 and the gate electrodes 130. The studs 185 may have a plug shape, and the cell interconnection lines 180 may have a line shape, but some example embodiments thereof are not limited thereto. The studs 185 and cell interconnection lines 180 may include metal, for example, tungsten (W), copper (Cu), aluminum (Al), or the like.

An upper insulating layer 190 may be disposed to cover the cell interconnection lines 180 on the cell region insulating layer 150. The upper insulating layer 190 may be formed of an insulating material, and may include at least one of, for example, SiO, SiN, SiCN, SiOC, SiON, and/or SiOCN.

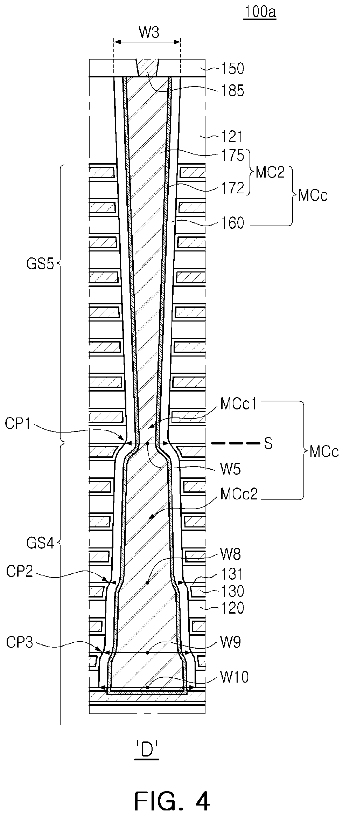

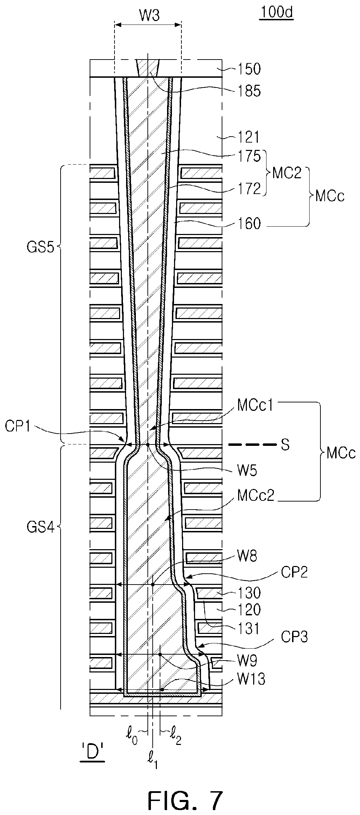

FIGS. 4 and 7 are cross-sectional diagrams illustrating a semiconductor device according to some example embodiments.

The semiconductor device 100a in FIG. 4 may be the same as the semiconductor device 100 in FIGS. 1 to 3D other than the shapes of the first-type contact structure MCa and the third-type contact structure MCc.

The third-type contact structure MCc may have a structure in which the second-type contact structure MCb and the first-type contact structures MCa are connected to each other.

The third-type contact structure MCc may have a length longer than the length of one stage of the stack structure GS. In the case in which at least one stage of the stack structure GS is disposed above the gate electrode 130, the third-type contact structure MCc may include a first portion MCc1 corresponding to the length of at least one stage of the stack structure GS completely penetrated, and a second portion MCc2 connected to a lower surface of the first portion MCc1 and extending below the first portion MCc1 to the level at which the corresponding gate electrode 130 is disposed.

The shape of the first portion MCc1 may be similar to the shape of the second-type contact structures MCb, and the shape of the second portion MCc2 may be similar to the shape of the first-type contact structures MCa. Since the first portion MCc1 of the third-type contact structure MCc is the same as the first portion MCc1 of the third-type contact structure MCc in FIG. 3D, the description thereof will not be provided, and the second portion MCc2 will be mainly described. Also, the description of the second portion MCc2 may replace the description of the first-type contact structure MCa.

The second portion MCc2 may be disposed such that the second portion MCc2 may extend from the upper surface of the mth stack structure (GSm, m = 1, 2, 3, 4) below the first portion MCc1 to the upper surface of the corresponding gate electrode 130.

The second portion MCc2 may have a width increasing from the upper surface to the lower surface.

The first portion MCc1 and the second portion MCc2 may include a first curved portion CP at the boundary surface S between stages of the stack structure GS. Differently from the bent portion BP, the first curved portion CP may not have a sharp corner (e.g. discontinuity), and may be defined as having an inflection point forming a curved (e.g. gently curved) surface and having a slope which changes.

The second portion MCc2 may include at least one more curved portion CP below the first curved portion CP in addition to the first curved portion CP depending on a length. Specifically, as illustrated in FIG. 4, each time the second portion MCc2 penetrates the 2^{N} (N=0, 1, 2, 3,...)th gate electrodes 130 below the first portion MCc1, an additional curved portion CP may be provided.

In FIG. 4, the second portion MCc2 may penetrate seven gate electrodes 130, and may include the second curved portion CP2 on the upper surface of the 4th gate electrode 130 from the first portion MCc1 and the third curved portion CP3 on the upper surface of the 6th gate electrode 130, which is the 2nd gate electrode 130 from the 4th gate electrode 130. That is, depending on the number of gate electrodes 130 penetrated by the second portion MCc2, an additional curved portion CP may be disposed in the upper surface of the 2^{N}th gate electrode 130. The curved portion CP may include an inflection point formed as a width of the lower portion further rapidly increases than the width of the upper portion, and when the side surface slope of the upper portion of the curved portion CP and the side surface slope of the lower portion of the curved portion CP are different, the region may be defined as a region continuously connecting the two side surfaces to each other.

When the second portion MCc2 penetrates one, two, or four gate electrodes 130, the second portion may include only the first curved portion CP without including an additional curved portion CP, and when the second portion MCc2 penetrates three gate electrodes 130, an additional curved portion CP may be included on the upper surface of the second gate electrode 130 downwardly from the first portion MCc1. When the second portion MCc2 penetrates five and six gate electrodes 130, an additional curved portion CP may be included on the upper surface of the fourth gate electrode 130 downwardly from the first portion MCc1, and as illustrated in FIG. 4, when the second portion MCc2 penetrates seven gate electrodes 130, additional second and third curved portions CP2 and CP3 may be included on the upper surfaces of the fourth and sixth gate electrodes 130 downwardly from the first portion MCc1.

In some example embodiments, each of the stack structures GS1, GS2, GS3, GS4, and GS5 of one stage of the stack structure GS may include eight gate electrodes 130, and when a greater number of gate electrodes 130 are included, a greater number of curved portions CP may be included.

In FIG. 4, when an additional curved portion CP is disposed on the upper surface of the 2^{N}th gate electrode 130 according to the number of gate electrodes 130 penetrated by the second portion MCc2, the curved portion CP may be disposed in the 4th, 2nd, and 1st order, or the curved portion CP may be disposed in the opposite order, in the order of the 1st, 2nd, and 4th.

When a plurality of curved portions CP are disposed in the second portion MCc2, the width of the curved portions CP may rapidly increase from the upper end to the lower end of the second portion MCc2, and the curved portion CP may have an increasing width toward a lower end. For example, in FIG. 4, the width W8 of the second curved portion CP2 may be greater than the width W5 of the upper end of the second portion MCc2, the width W9 of the third curved portion CP3 may be greater than the width W8 of the second curved portion CP2, and the width W10 of the lower end may be the greatest. In this case, the width W10 of the lower end may be greater than the width of the lower end when extending from the upper end of the second portion MCc2 to the second curved portion CP2 by a slope to the lower end (FIG. 3D). The lower end of the second portion MCc2 may include a portion of reduction portions as in FIG. 3D, but some example embodiments thereof are not limited thereto.

The curved portions CP1-CP3 may be formed by wet etching the second portion MCc2 multiple times, and by representing the level of each gate electrode 130 in binary (2ⁿ), when the contact holes in contact with the gate electrodes 130 at different levels are formed at different depths by the same number of etchings as the number of binary digits, the holes may be formed at different depths according to the number of etchings. In this case, the first portion MCc1 of the second-type contact structure MCb and the third-type contact structure MCc may be etched together with the channel hole of the channel structure CH, such that the number of additional etchings of the contact structures MCb and MCc through wet etching may be reduced (for example, significantly), and the etching depth etched at one time may also be reduced (for example, significantly).

The second width W2 of the upper surface of the second-type contact structure MCb not performing repeated wet etching may be the smallest, and the third width W3 of the third-type contact structure MCc performing repeated wet etching may be the same as or greater than the first width W1 of the first-type contact structure MCa.

Also, the contact structures MCb, MCc extending by penetrating a plurality of stack structures GS in the contact structures MCa, MCb, and MCc may have a bent portion BP at the same level as a portion of the bent portions BP of the channel structure CH.

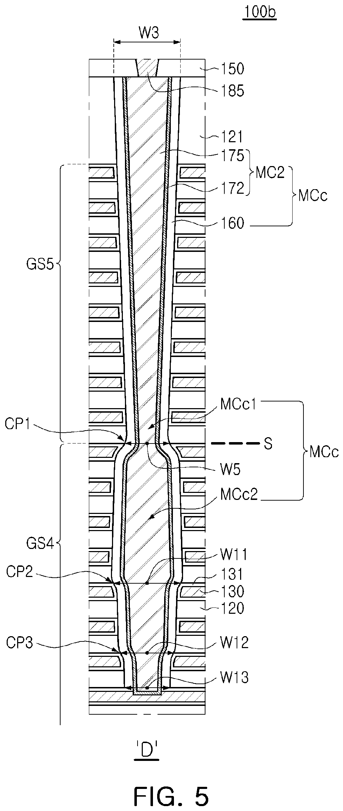

The semiconductor device 100b in FIG. 5 may be the same as the semiconductor device 100 in FIGS. 1 to 3D other than the shapes of the first-type contact structure MCa and the third-type contact structure MCc.

The third-type contact structure MCc in FIG. 5 may have a structure in which the second-type contact structure MCb and the first portion MCc1, which are the same as the first-type contact structures MCa and the second portion MCc2, are coupled to each other, and since the coupling structure is the same as the third-type contact structure MCc in FIG. 4, the description of the first portion MCc1 will not be provided.

A width of the second portion MCc2 of the third-type contact structure MCc in FIG. 5 may increase from the upper surface downwardly, and may decrease in the curved portion CP. The boundary between the first portion MCc1 and the second portion MCc2 may include the first curved portion CP at the boundary surface S of the stack structure GS. The first curved portion CP may not have a corner different from the bent portion BP, and may have an inflection point at which a curved surface is gently formed and a slope changes.

The second portion MCc2 of the third-type contact structure MCc may further include another curved portion CP below the first curved portion CP1 according to the length.

Specifically, as illustrated in FIG. 5, when the second portion MCc2 penetrates the 2^{N} (N=0, 1, 2, 3,...) gate electrodes 130 below the first portion MCc1, the curved portion CP may be included in at the 2^{N}th gate electrode 130 below the first portion MCc1.

The curved portion CP may be defined as a region including an inflection point formed as the width of the lower portion decreases more rapidly than the width of the upper portion, and additional curved portions CP may be disposed on the upper surface of the 2^{N}th gate electrode 130.

When the second portion MCc2 penetrates 1, 2, and 4 gate electrodes 130, the second portion MCc2 may include only the first curved portion CP without including an additional curved portion CP. For example, when the second portion MCc2 penetrates 3 gate electrodes 130, the second portion MCc2 may include an additional curved portion CP on the upper surface of the second gate electrode 130 downwardly from the first portion MCc1. When the second portion MCc2 penetrates 5 and 6 gate electrodes 130, the second portion MCc2 may include an additional curved portion CP on the upper surface of the fourth gate electrode 130 downwardly from the first portion MCc1. As illustrated in FIG. 4, when the second portion MCc2 penetrates 7 gate electrodes 130, the second portion MCc2 may include additional second and third curved portions CP2 and CP3 on the upper surfaces of the fourth and sixth gate electrodes 130 downwardly from the first portion MCc1.

In some example embodiments, one stage of the stack structure GS may include eight gate electrodes 130, and when the stage includes a greater number of gate electrodes 130, a greater number of curved portions CP may be included.

When a plurality of curved portions CP are disposed in the second portion MCc2, a width of the curved portions CP decreases rapidly from an upper end to a lower end of the second portion MCc2, and the lower end may have the smallest width W13. For example, in FIG. 5, the width W11 of the second curved portion CP2 may be greater than the width W5 of the upper end of the second portion MCc2, and the width W11 may decrease rapidly while passing the second curved portion CP2, and the width W12 of the third curved portion CP3 may be smaller than the width W11 of the second curved portion CP2, and the width W12 may decrease rapidly while passing through the third curved portion CP3, such that the width W13 of the lower end may be the smallest. In this case, the width W13 of the lower end may be much smaller than the width of the lower end when extending from the upper end of the second portion MCc2 to the second curved portion CP2 by a slope to the lower end (as shown in FIG. 3D). The lower end may include a portion of reduction portions as in FIG. 3D, but some example embodiments thereof are not limited thereto.

The curved portions CP may be formed by extending the contact hole downwardly through etching the second portion MCc2 multiple times.

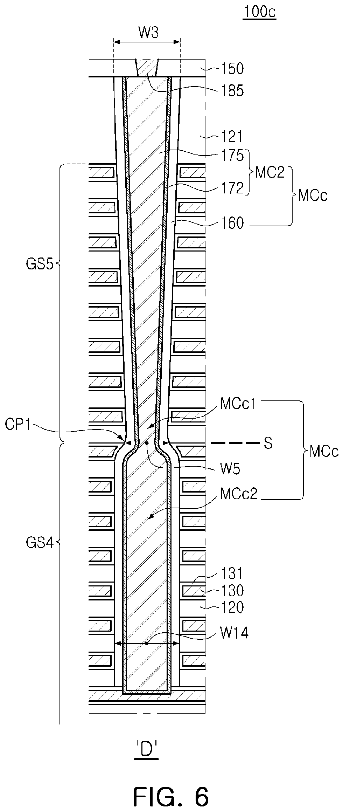

The semiconductor device 100c in FIG. 6 may be the same as the semiconductor device 100 in FIGS. 1 to 3D other than the shapes of the first-type contact structure MCa and the third-type contact structure MCc.

The third-type contact structure MCc in FIG. 6 may have a structure in which a first portion MCc1 the same as the second-type contact structure MCb and a second portion MCc2 the same as the first-type contact structures MCa are coupled to each other, and since the coupling structure is the same as the third-type contact structure MCc in FIG. 5, the description of the first portion MCc1 will not be provided.

The second portion MCc2 of the third-type contact structure MCc in FIG. 6 may be formed such that the width W14 may be substantially uniform from the upper portion to the lower portion. The first portion MCc1 and the second portion MCc2 may include a curved portion CP on the boundary surface S of the stack structure GS, the lower surface of the first portion MCc1 and the upper surface of the second portion MCc2 may be continuously connected to each other, and may have the same width W5. In the upper portion of the second portion MCc2, a curved surface portion of which a width of the upper surface may extend to satisfy a predetermined or alternatively desired width W14. When the second portion MCc2 satisfies the predetermined or alternatively desired width W14, the second portion may extend to the lower end while maintaining the predetermined or alternatively desired width W14.

Accordingly, the second portion MCc2 of the third-type contact structure MCc may have a similar shape regardless of a length thereof, may represent the level of each gate electrode 130 in binary (2ⁿ), and when contact holes having various depths in contact with gate electrodes at different levels are formed by performing the same number of digits as the binary number, a contact hole may be formed to maintain a predetermined or alternatively desired width W14 by a plurality of etching processes. Also, in the first-type contact structures MCa, when contact holes having various depths within the uppermost stack structure GS5 in contact with gate electrodes at different levels are formed by performing etching the same number of times as the number of digits of the binary system, a contact hole may be formed to maintain a predetermined or alternatively desired width by a plurality of etching processes.

The semiconductor device 100d in FIG. 7 may be the same as the semiconductor device 100a in FIG. 4 other than the shapes of the first-type contact structure MCa and the third-type contact structure MCc.

The third-type contact structure MCc may have a structure in which the second-type contact structure MCb and the first-type contact structures MCa are coupled to each other.

The third-type contact structure MCc may have a length longer than the length of one stage of the stack structure GS. When a plurality of stack structures GS are disposed above the allocated gate electrode 130, the first portion MCc1 corresponding to the length of the plurality of stack structures GS completely penetrating may be included, and the second portion MCc2 extending to the level at which the allocated gate electrode 130 is disposed below the first portion MCc1 may be included.

The shape of the first portion MCc1 may be similar to the second-type contact structures MCb, and the shape of the second portion MCc2 may be similar to the first-type contact structures MCa. Since the shape of the first portion MCc1 is the same as the previous description, the description will not be provided, and since the shape of the second portion MCc2 is the same as the first-type contact structure MCa, the description of the first-type contact structure MCa may be replaced with the description of the second portion MCc2.

The second portion MCc2 may be disposed such that the second portion may extend from the upper surface of the stack structure GS, in which the gate electrode 130 allocated below the first portion MCc1 is disposed, to the upper surface of the allocated gate electrode 130. The second portion MCc2 may have a width increasing from the upper surface to the lower surface.

The first portion MCc1 and the second portion MCc2 may include a first curved portion CP in the interfacial surface of the stack structure GS. Differently from the bent portion BP, the first curved portion CP may not have a corner, and may be defined as having an inflection point forming a gently curved surface and having a slope which changes. In addition to the first curved portion CP, the second portion MCc2 may further include another curved portion CP below the first curved portion CP. Specifically, as illustrated in FIG. 7, when the second portion MCc2 penetrates the 2^{N} (N=0, 1, 2, 3,...)th gate electrodes 130 below the first portion MCc1, the 2^{N}th gate electrode 130 below the first portion MCc1 may have the curved portion CP.

FIG. 7 illustrates the example in which the second portion MCc2 penetrates seven gate electrodes 130, and accordingly, the second curved portion CP and the third curved portion CP may be included on the upper surface of the 4^{th} gate electrode 130 from the first portion MCc1, the 6^{th} gate electrode 130 which is the 2^{nd} gate electrode 130 from the 4^{th} gate electrode 130.

Depending on the number of gate electrodes penetrated by the second portion MCc2, an additional curved portion CP may be disposed on the upper surface of the 2^{N}th gate electrode, and the curved portion CP may include an inflection point formed as the width of the lower portion increases rapidly as compared to the width of the upper portion.

In some example embodiments, one stage of the stack structure may include eight gate electrodes 130, and when a greater number of gate electrodes are included, a greater number of curved portion CPs may be included.

In the case in which the plurality of curved portion CPs are disposed in the second portion MCc2, the width of the curved portions CP may rapidly expand from the upper surface of the second portion MCc2 to the lower end, and may have an increasing width toward the lower end. As illustrated in FIG. 3D, the lower end may include a portion of reduction portions, but some example embodiments thereof are not limited thereto.

The curved portion CP may be formed by extending the contact hole downwardly through successive wet etching of the second portion MCc2. In this case, when a central line extending in the Z-direction through a center of the width from the first portion MCc1 to the second curved portion CP is defined as the first virtual line l0, a central line of the width from the second curved portion CP2 to the third curved portion CP is defined as the second virtual line l1, and a central line of the width from the third curved portion CP3 to the lower end is defined as the third virtual line l2, the second virtual line 11 may be offset without being coaxial with the first virtual line l0, and the third virtual line l2 may be offset without being coaxial with the second virtual line l1. Accordingly, the second portion MCc2 may be disposed asymmetrically with respect to the first virtual line l0. For example, as illustrated in FIG. 7, one side surface of the second portion MCc2 may maintain a vertical linear line in the Z-direction from the first curved portion CP to the lower end, and the first curved portion CP1, the second curved portion CP2, and the third curved portion CP3 may be disposed in order on the other side surface. In this case, the third virtual line l2 may be disposed farther from the first virtual line l0 than the second virtual line l1, and the third virtual line l2 may satisfy a predetermined or alternatively desired width in the Z-direction by being disposed within the range of the width W5 of the lower end of the first portion MCc1.

In the contact hole process forming the second portion MCc2, by representing the level of each gate electrode 130 in binary (2ⁿ), a contact hole in contact with the entire gate electrode 130 may be formed by etching the same number of times as the number of digits of the binary system. In this case, even when misalignment occurs while forming each curved portion CP by one-time etching, a third-type contact structure MCc may be formed by a plurality of etching processes because the continuous area in the Z-direction satisfies a predetermined or alternatively desired value.

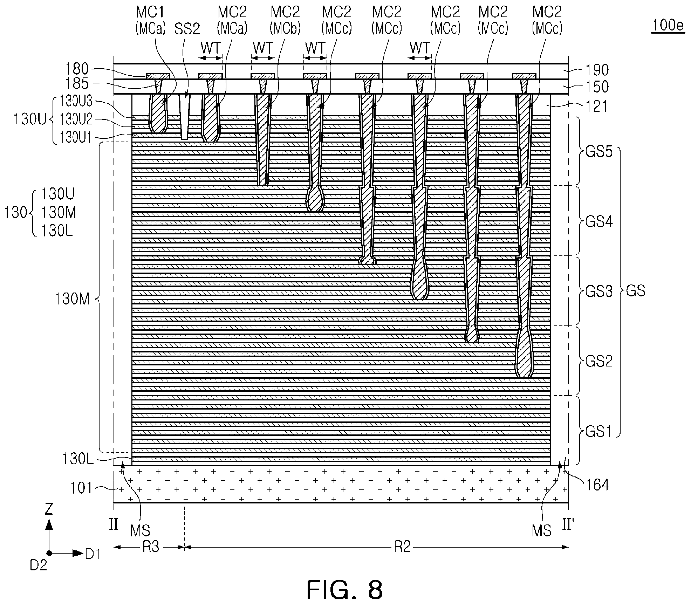

Hereinafter, semiconductor devices according to some example embodiments will be described with reference to FIGS. 8 to 11.

FIG. 8 is a cross-sectional diagram illustrating a semiconductor device 100e corresponding to FIG. 2B, and the semiconductor device 100e in FIG. 8 may be the same as the semiconductor device 100 in FIGS. 1 to 3D other than the sizes of the contact structures MCa, MCb, and MCc.

Referring to FIG. 8, the contact structures MCa, MCb, and MCc may include first-type, second-type, and third-type contact structures MCa, MCb, and MCc, and an upper surface width WT of the first-type contact structure MCa may be the same as an upper surface width WT of the second-type contact structure MCb, and the upper surface width WT of the second-type contact structure MCb may be substantially the same as the upper surface width WT of the third-type contact structure MCc.

The first-type, second-type and third-type contact structures MCa, MCb and MCc may be formed through different types of etching processes performed in different orders, and the processes may be performed different times, and even in this case, the upper surface widths WT of the first-type, second-type and third-type contact structures MCa, MCb and MCc may be substantially the same as final structures.

To this end, in the high aspect ratio contact (HARC) etching process of forming the first portion MCc1 of the second-type contact structure MCb and the third-type contact structure MCc, a mask opening width forming the first portion MCc1 of the third-type contact structure MCc may be smaller than a mask opening width forming the second-type contact structure MCb. The upper portion widths WT of the first and third-type contact structures MCa and MCc to which multiple or different etching processes are applied and the second-type contact structure MCb to which only the HARC etching process is applied may be formed to be the same, thereby preventing or reducing in likelihood misalignment with the stud 185 disposed on the contact structures MCa, MCb, and MCc.

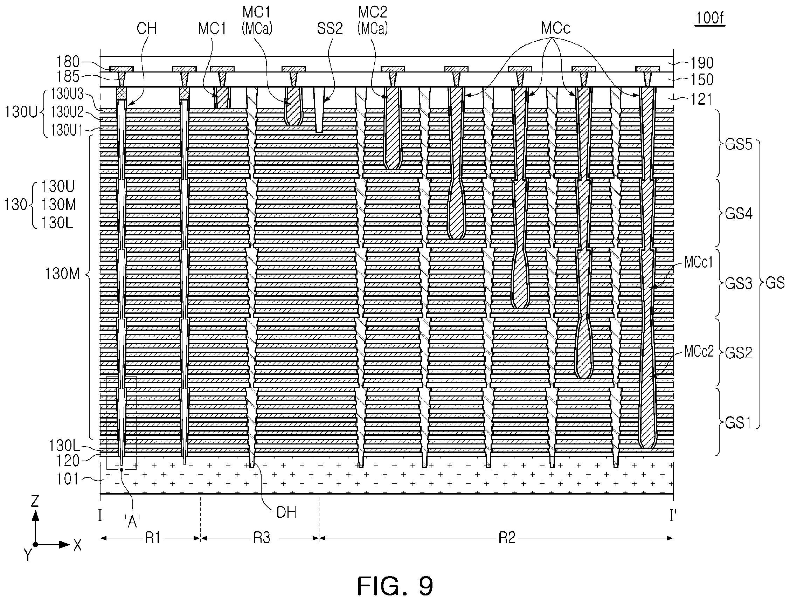

FIG. 9 is a cross-sectional diagram illustrating a semiconductor device 100f corresponding to FIG. 2A, and the semiconductor device 100f in FIG. 9 may be the same as the semiconductor device 100 in FIG. 1 to FIG. 3D, other than the third-type contact structure MCc.

Referring to FIG. 9, the third-type contact structure MCc, which is the lowermost stage of the third-type contact structures MCc, that is, the third-type contact structure MCc in contact with the gate electrode 130 of the first stack structure GS 1, may have a length of the second portion MCc2 greater than a length of one stage of the stack structure GS.

Specifically, the third-type contact structures MCc disposed at a level higher than a level of the lowermost stage and in contact with the gate electrode 130 of the second to fourth stack structures GS2-GS4 may have a length, for example a maximum length, of the second portion MCc2 smaller than the length of one stage of the stack structure GS. The third-type contact structures MCc disposed in contact with the gate electrode 130 of the first stack structure GS1, which is the lowermost stage, may have the second portion MCc2 connected from the lower end of the first portion MCc1, and the length thereof may be greater than the entire length of the second stack structure GS2.

That is, the first portion MCc1 of the MCc of the third-type contact structure may be disposed by a length penetrating the stack structure GS3-GS5 of the third stage from the lower portion, and the second portion MCc2 may be disposed from the upper surface of the second stack structure GS2, which is the second stage, to the allocated gate electrode 130 of the first stack structure GS 1 from the lower portion.

As described above, contact holes of the contact structures MCc, which are formed simultaneously with the channel holes of the channel structure CH, may not be formed other than the stack structure GS1 of the last stage, and may not be formed in the stack structures GS1 and GS2 of the two stages below, and may be formed only in the stack structures GS3-GS5 disposed in an upper portion. By reducing the number of bent portion BPs, physical/electrical short circuits due to a sharp difference in width may be prevented or reduced in likelihood.

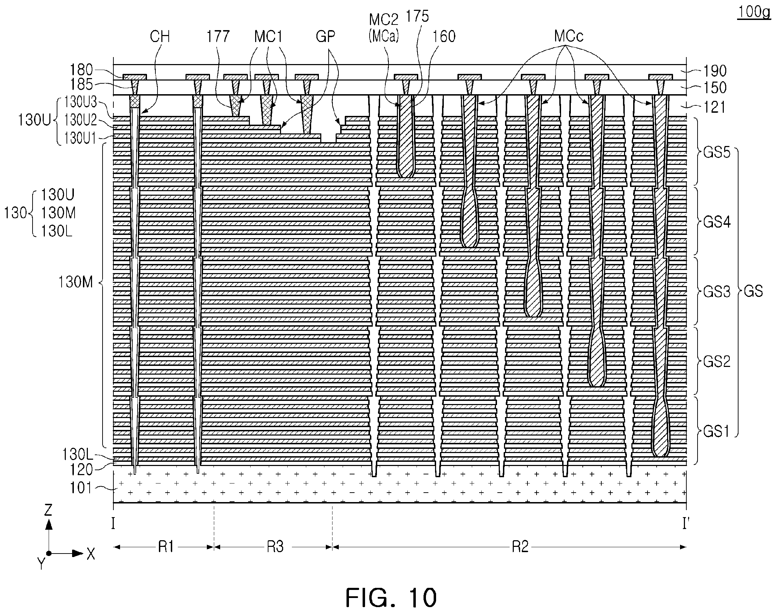

Referring to FIG. 10, the semiconductor device 100g may be the same as the semiconductor device 100 in FIGS. 1 to 3D other than the structure of the string select contact plug MC1 and the upper gate electrodes 130U of the string select line. The semiconductor device 100g may have different shapes of the first string select contact plug MC1 and the wordline contact plugs MC2.

The upper gate electrodes 130U may include a contact region to be in contact with the first and second string select contact plug MC1 in the string select region R3 and the second string select region R2b, and may include a step structure GP having a staircase shape such that the contact region may be exposed.

When three upper gate electrodes 130U1-130U3 are allocated as string select lines, the three upper gate electrodes 130U1-130U3 may have a step structure GP having a staircase shape of which a length may increase downwardly. Accordingly, a dummy step structure GP of a staircase shape may also be formed in the extension region R2 on the opposite side, and a step width of the dummy step structure GP of the extension region R2 and a step width of the step structure GP of the string select region R3 may be different from each other. For example, the step width of the dummy step structure GP of the extension region R2 may be narrower than the step width of the step structure GP of the string select region R3, but some example embodiments thereof are not limited thereto. Depending on the step structure GP of the staircase shape, string select contact plugs MC1 may be disposed to be in contact with each of the contact regions of the string select lines exposed.

The string select contact plugs MC1 may be formed with only the conductive layer 177. That is, only the conductive layer 177 may be disposed in the form of a plug without a side surface insulating layer and may be disposed in contact with an upper surface of the contact region of the exposed upper gate electrode 130U. In this case, the contact barrier layer surrounding the conductive layer may be disposed further by surrounding the conductive layer 177, but some example embodiments thereof are not limited thereto.

A step structure GP having a staircase shape may be formed between the string select region R3 and the extension region R2, such that the upper gate electrodes 130U1-130U3 may be cut, such that the second insulating region SS2 may not be disposed separately.

In the extension region R2, the wordline contact plugs MC2 may be disposed to be in contact with the gate electrodes 130M and 130L, which are lower levels than the upper gate electrodes 130U1-130U3, respectively, and the wordline contact plugs MC2 may satisfy the shapes of the first-type, second-type and third-type contact structures MCa, MCb and MCc described above. That is, the shape may be the same as the shapes in FIG. 2A to FIG. 3D including the plug conductive layer 175 and the side insulating layer 160.

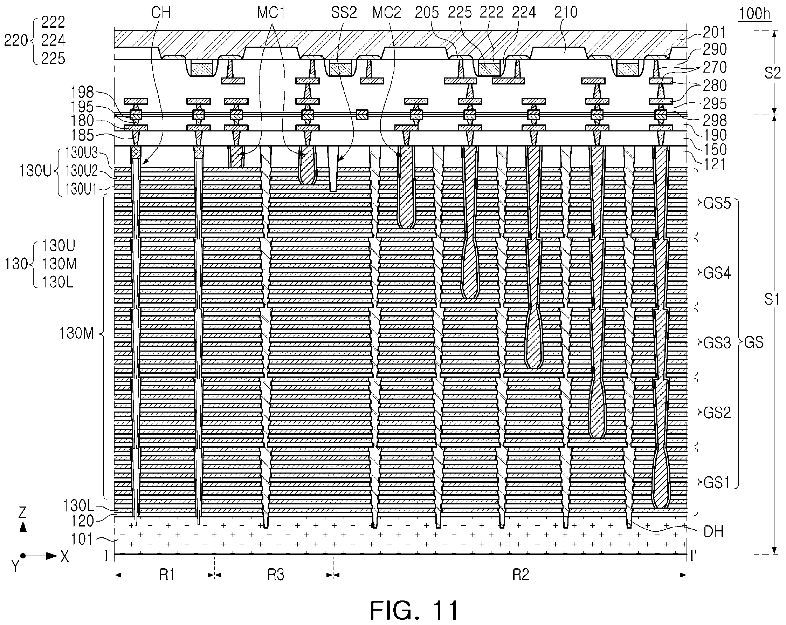

The semiconductor device 100h in FIG. 11 may include the semiconductor device 100 in FIGS. 1 to 4D as a first semiconductor structure S1, and a second semiconductor structure S2 may be disposed as a peripheral circuit structure on the first semiconductor structure S1. The first semiconductor structure S1 may be stacked in a Z-direction, which is vertical to the second semiconductor structure S2. Specifically, the first semiconductor structure S1 may be disposed below the second semiconductor structure S2 in the Z-direction. In some example embodiments, conversely, the second semiconductor structure S2 may be disposed below the first semiconductor structure S1.

The first semiconductor structure S1 may further include a bonding structure. Specifically, first bonding vias 195, first bonding metal layers 198, and a first bonding insulating layer may form the first bonding structure of the first semiconductor structure S1. The first bonding vias 195 may be disposed on the cell interconnection lines 185, and the first bonding metal layers 198 may be connected to the first bonding vias 195. The first bonding metal layers 198 may have an upper surface exposed to the upper surface of the first semiconductor structure S1. The first bonding metal layers 198 may be bonded and connected to the second bonding metal layers 298 of the second semiconductor structure S2. The first bonding vias 195 and the first bonding metal layers 198 may include a conductive material, for example, copper (Cu). The first bonding insulating layer may form a dielectric-dielectric bonding with the second bonding insulating layer of the second semiconductor structure S2.

The second semiconductor structure S2 may include a substrate 201, source/drain regions 205 and device isolation layers 210 within the substrate 201, circuit elements 220 disposed on the substrate 201, a peripheral region insulating layer 290, circuit contact plugs 270, circuit interconnection lines 280, second bonding vias 295 and second bonding metal layers 298.

The substrate 201 may have a lower surface extending in the X-direction and the Y-direction. An active region may be defined in the substrate 201 by the device isolation layers 210. Source/drain regions 205 including impurities may be disposed in a portion of the active region. The substrate 201 may include a semiconductor material, for example, a group IV semiconductor, a group III-V compound semiconductor or a group II-VI compound semiconductor. The substrate 201 may be a bulk wafer or may be provided as an epitaxial layer.

The circuit elements 220 may include a planar transistor. Each of the circuit elements 220 may include a circuit gate dielectric layer 222, a spacer layer 224 and a circuit gate electrode 225. The source/drain regions 205 may be disposed as source/drain regions within the substrate 201 on both sides of the circuit gate electrode 225.

The peripheral region insulating layer 290 may be disposed to cover the circuit elements 220 on a lower surface of the substrate 201. The peripheral region insulating layer 290 may include a plurality of insulating layers formed in different processes. The peripheral region insulating layer 290 may be formed of an insulating material. A portion of the peripheral region insulating layer 290 may function as a second bonding insulating layer.

Circuit contact plugs 270 and circuit interconnection lines 280 may form a circuit interconnection structure electrically connected to the circuit elements 220 and the source/drain regions 205. The circuit contact plugs 270 may have a cylindrical shape, and the circuit interconnection lines 280 may have a line shape. An electrical signal may be applied to the circuit elements 220 by the circuit contact plugs 270 and the circuit interconnection lines 280. In a region not illustrated, the circuit contact plugs 270 may also be connected to the circuit gate electrode 225. The circuit interconnection lines 280 may be connected to the circuit contact plugs 270 and may be disposed in a plurality of layers. The circuit contact plugs 270 and the circuit interconnection lines 280 may include a conductive material, for example, tungsten (W), copper (Cu), aluminum (Al), or the like, and each of the components may further include a diffusion barrier. In some example embodiments, the number of layers of the circuit contact plugs 270 and the circuit interconnection lines 280 may be varied.

The second bonding vias 295 and the second bonding metal layers 298, and the second bonding insulating layer may be included in a second bonding structure and may be disposed below a portion of the lowermost portion of the circuit interconnection lines 280. The second bonding vias 295 may have a cylindrical shape, and the second bonding metal layers 298 may have a pad shape having a circular shape in a plane or a relatively short line shape. Lower surfaces of the second bonding metal layers 298 may be exposed to a lower surface of the second substrate structure S2. The second bonding vias 295 and the second bonding metal layers 298 may provide electrical connection paths with the first semiconductor structure S1. In some example embodiments, a portion of the second bonding metal layers 298 may not be connected to the circuit interconnection lines 280 and may be disposed only for bonding. The second bonding vias 295 and the second bonding metal layers 298 may include a conductive material, for example, copper (Cu).

The second bonding insulating layer may be defined from a lower surface of the peripheral region insulating layer 290 to a predetermined or alternatively desired thickness, but may also be implemented as an insulating layer on a lower surface of the peripheral region insulating layer 290. The second bonding insulating layer may be provided for dielectric-dielectric bonding with the first bonding insulating layer of the first semiconductor structure S1. The second bonding insulating layer may also function as a diffusion barrier for the second bonding metal layers 298 and may include, for example, at least one of SiO, SiN, SiCN, SiOC, SiON, and SiOCN.

The first and second semiconductor structures S1 and S2 may be bonded to each other by bonding between the first bonding metal layers 198 and the second bonding metal layers 298 and bonding between the first bonding insulating layer and the second bonding insulating layer. The bonding between the first bonding metal layers 198 and the second bonding metal layers 298 may be, for example, copper (Cu)-copper (Cu) bonding, and the bonding between the first bonding insulating layer and the second bonding insulating layer may be, for example, dielectric-dielectric bonding, such as SiCN-SiCN bonding. The first and second semiconductor structures S1 and S2 may be bonded to each other by hybrid bonding including copper (Cu)-copper (Cu) bonding and dielectric-dielectric bonding.

The first and second semiconductor structures S1 and S2 may be packaged in a form in which the first semiconductor structure S1 is disposed below the second semiconductor structure S2 as illustrated in FIG. 11, or may be packaged in a form in which the second semiconductor structure S2 is disposed below the first semiconductor structure S1 upside down.

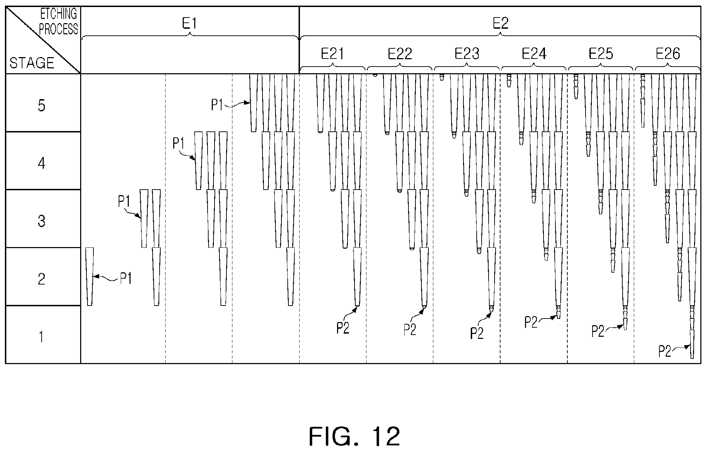

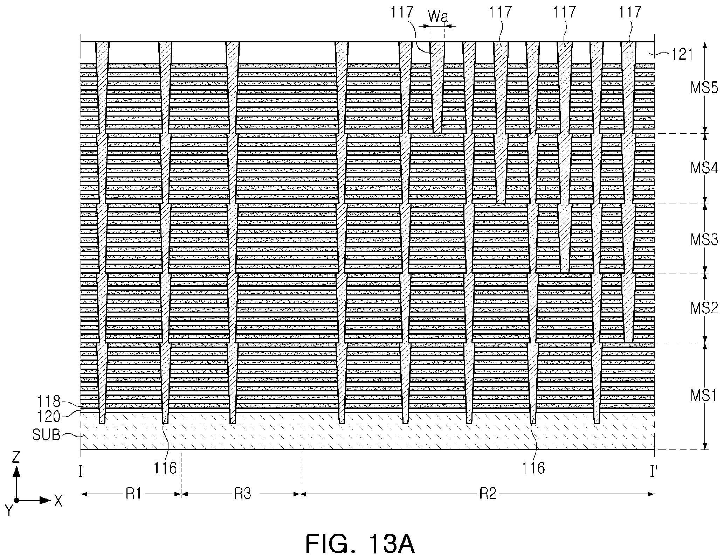

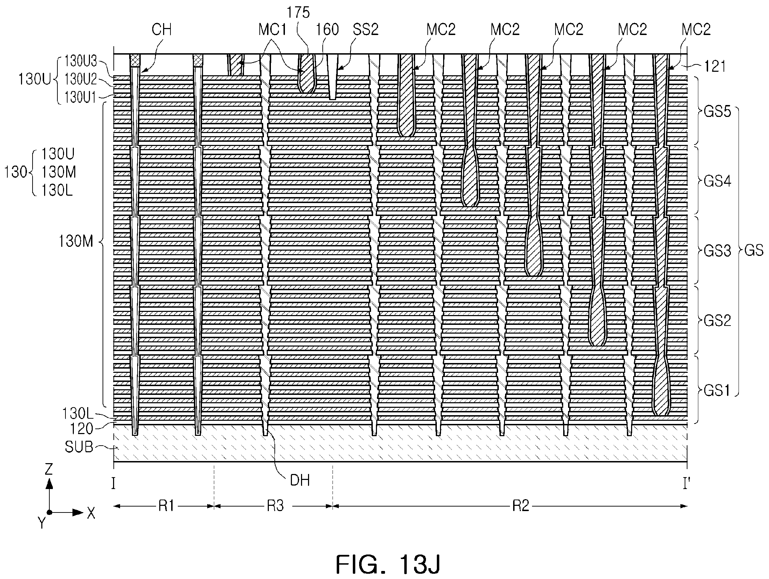

FIG. 12 and FIG. 13A to FIG. 13l illustrate a method of manufacturing a semiconductor device according to some example embodiments.

FIG. 12 is a diagram illustrating an etching process for forming a contact hole of a semiconductor device according to some example embodiments, and FIG. 13A to FIG. 13l are cross-sectional diagrams illustrating a method of manufacturing a semiconductor device according to some example embodiments, illustrating cross-sections corresponding to FIG. 2A.

FIG. 12 illustrates a contact hole forming process for forming contact structures MCa, MCb, and MCc among processes of the methods of manufacturing a semiconductor device according to some example embodiments.

In FIG. 12, each column may represent the number of stages of the mold structure MS replaced with the stack structure GS, each row may represent an etching process, and each figure may represent the shape of the contact hole of each stage to which the corresponding etching process is performed.

As described in FIGS. 1 to 3D, the contact structures MCa, MCb, and MCc of the semiconductor device 100 may have different lengths depending on a level of the gate electrode 130 in contact with each other. To form the contact structures Mca, MCb, and MCc having different lengths, contact holes having corresponding depths may be formed in regions corresponding to the contact structure MCa, MCb, and MCc, respectively. Corresponding etching processes among the etching processes illustrated in FIG. 12 may be performed to the contact holes, respectively, depending on a depth thereof.

The etching process for the contact hole may be classified into a HARC etching process E1 and a contact hole portion etching process E2.

Specifically, when the stack structures GS1-GS5 of five stages are formed, in each of the mold structures MS1-MS5 corresponding thereto, in the case of the contact structures MS2 and MS3 penetrating the entire mold structures MS1-MS5 within the mold structures MS1-MS5 of each stage, when the channel hole of the channel structure CH is formed, the first portions of the contact hole penetrating the entire mold structures MS1-MS5 of the corresponding stages may be formed by performing a HARC etching process simultaneously.

As for the first portions of the contact hole through the HARC etching process E1, after the first mold structure MS1 is formed, the first HARC etching process penetrating the first mold structure MS1 is performed and when a channel hole corresponding to the first channel portion CH1 of the channel structure CH1 is formed, the first portions of the contact hole may not be formed.

After the second mold structure MS2 is formed during the HARC etching process E1, the second HARC etching process penetrating the second mold structure MS2 may be performed, and when the channel hole corresponding to the second channel portion CH2 of the channel structure CH is formed, the first portions P1 of the contact hole may also be formed together.

When the HARC etching process E1 is repeated for each of the mold structures MS2-MS5, the first portions P1 of the contact hole corresponding to the fifth mold structure MS5 may be formed.

In the case of the contact structures MCb and MCc penetrating an entire section of the stack structure GS by the repeated HARC etching process E1, the first portions P1 of the contact hole penetrating the stack structure GS may be formed, and a plurality of HARC etching processes may be applied depending on the lengths of the contact structures MCb and MCc, such that a bent portion BP may be formed between the first portions P1 of the plurality of contact holes.

In the subsequent process, the contact hole portion etching process E2 for the third-type contact structure MCc having a length exceeding one stage of the stack structure GS among the contact structures MCa, MCb, and MCc and the first-type contact structure MCa in contact with the gate electrodes 130 of the uppermost fifth stack structure GS5 may be performed.

The contact hole portion etching process E2 may form contact holes having different depths exposing the gate electrodes 130 of the entirety of levels by performing additional etchings the same number of times as the number of binary digits when each gate electrode 130 is represented in binary.

In FIG. 12, the gate electrodes 130 within the stack structure GS of one stage may be etched six times, thereby forming contact holes in which the entirety of the gate electrodes 130 are exposed.

Specifically, in the first portion etching E21, etching for penetrating the gate electrode 130 of the one layer may be performed, in the second portion etching E22, etching for simultaneously penetrating the gate electrodes 130 of the two layers may be performed, in the third portion etching E23, etching simultaneously penetrating the gate electrodes 130 of the four layers may be performed, in the fourth partial etching E24, etching for simultaneously penetrating the gate electrodes 130 of the eight layers may be performed, in the fifth partial etching E25, etching for simultaneously penetrating the gate electrodes 130 of the 16 layers may be performed, and in the sixth portion etching E26, etching simultaneously penetrating the gate electrodes 130 of the 32 layers may be performed.

64 gate electrodes 130 in the stack structure GS of one stage may be disposed, and through 6 etching processes, contact holes exposing the gate electrodes 130, respectively, within the stack structure GS may be formed.

For example, a contact hole opening the 48^{th} gate electrode 130 from the upper portion within the stack structure GS of each stage may need to penetrate the gate electrodes 130 of the 47 (32+8+4+2+1 layers), which may be formed by applying the other etching processes other than the fifth etching process penetrating the gate electrodes 130 of the 16 layers among the six etching processes.

In some example embodiments, one stage may include the gate electrode 130 of the 8 layers, such that etching processes may be partially performed three times.

Accordingly, the contact structures MCb and MCc penetrating the stack structures GS2-GS5 of at least one stage may ensure the depth by forming the first portion of the contact hole simultaneously with the formation of the channel hole of the channel structure CH through the HARC etching process E1, thereby reducing the number of etching processes and/or the etching depth during the partial etching E2, and/or ensuring reliability of the device.

Specifically, referring to FIG. 13A, sacrificial insulating layers 118 and interlayer insulating layers 120 may be alternately stacked on the base substrate SUB, and may be formed up to the uppermost interlayer insulating layer 121. Vertical sacrificial structures 116 penetrating the mold structures MS1-MS5 may be formed.

The base substrate SUB may be removed through a subsequent process, and may be a semiconductor substrate such as a silicon (Si) wafer. First, a first mold structure MS1 of the mold structures MS1-MS5 may be formed, and a HARC etching E1 may be performed to penetrate the structures, and after a portion of vertical sacrificial structures 116 is formed, a second mold structure MS2 may be formed, a HARC etching E1 for penetrating the structure may be performed, and a portion of the vertical sacrificial structures 116 and a portion of the contact sacrificial structures 117 may be formed. A portion of the third to fifth mold structures MS3-MS5 and the vertical sacrificial structures 116 and a portion of contact sacrificial structures 117 may be formed in the same manner as above.

The sacrificial insulating layers 118 may be replaced with the gate electrodes 130 (see FIG. 2A) through a subsequent process. The sacrificial insulating layers 118 may be formed of a material different from a material of the interlayer insulating layers 120 and may be formed of a material etched with etch selectivity under specific etch conditions with respect to the interlayer insulating layers 120. For example, the interlayer insulating layer 120 may be formed of at least one of silicon oxide and silicon nitride, and the sacrificial insulating layers 118 may be formed of a material different from a material of the interlayer insulating layer 120 selected from among silicon, silicon oxide, silicon carbide, and silicon nitride. In some example embodiments, the thicknesses of the interlayer insulating layers 120 may not be the same, and the uppermost interlayer insulating layer 121 may have a thickness greater than thicknesses of the other interlayer insulating layers 120. The thicknesses and the numbers of films included in the interlayer insulating layers 120 and the sacrificial insulating layers 118 may be varied from the illustrated example.

The vertical sacrificial structures 116 may be formed in positions corresponding to the channel structures CH and the support structures DH in FIG. 2A. The vertical sacrificial structures 116 may be formed, for example, with the same size as those of the channel structures CH and the support structures DH. The vertical sacrificial structures 116 may include, for example, carbon (C), but some example embodiments thereof are not limited thereto.

The contact sacrificial structures 117 may be formed in positions corresponding to the first portion MCc1 among the second-type contact structures MCb and the third-type contact structures MCc among the contact structures in FIG. 2A. The upper stage of the contact sacrificial structures 117 may be formed to have an initial width Wa, and may be formed, for example, with the same size as the size of the second-type contact structure MCb. The contact sacrificial structures 117 may include, for example, carbon (C), but some example embodiments thereof are not limited thereto.

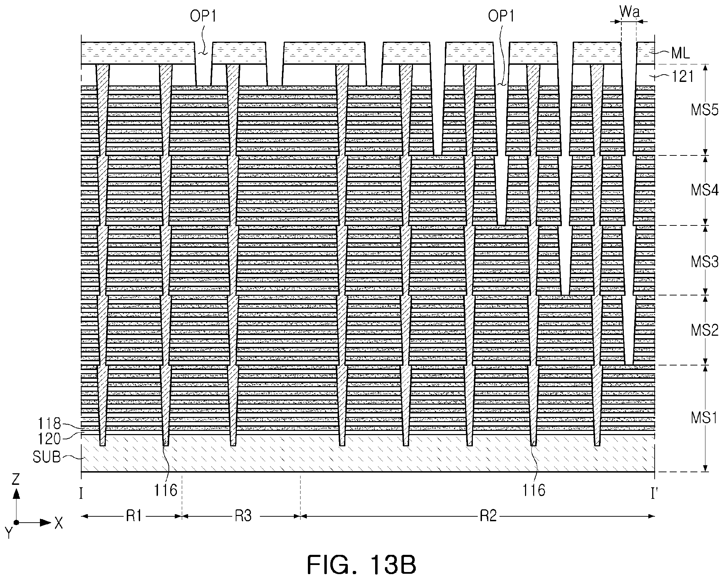

Referring to FIG. 13B, a mask layer ML may be formed on the uppermost interlayer insulating layer 121, and a first opening OP1 may be formed through therethrough.

The mask layer ML may include a photoresist layer. The first opening OP1 may be formed in a circular, elliptical, or similar shape in regions corresponding to the contact structures MCa, MCb, and MCc in FIG. 2A. The mask layer ML may be patterned, and accordingly, the uppermost interlayer insulating layer 121 may be removed, thereby forming the first opening OP1.

In this case, when the contact sacrificial structures 117 of the first opening OP1 are opened, the first opening OP1 may extend by removing the entirety of the contact sacrificial structures 117. Accordingly, the upper surface of each mold structures MS1-MS5 may be exposed in the region in which the contact sacrificial structures 117 are removed through the first opening OP1.

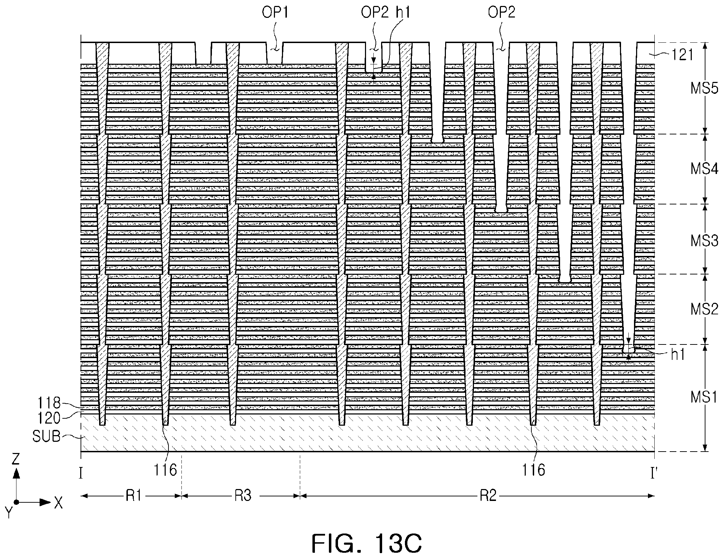

Referring to FIG. 13C, the second opening OP2 may be formed by etching the mold structures MS1-MS5 to penetrate one more layer of the sacrificial insulating layer 118 in a portion of the first opening OP1 which is opened.

The second opening OP2 may extend from the first opening OP1 by a first depth h1. For example, the contact structures MCa and MCc penetrating the number of gate electrodes 130 in the mold structures MS1-MS5 at each stage may be formed by etching a pair of the sacrificial insulating layer 118 and the interlayer insulating layer 120 by the first depth h1 below the first opening OP1.

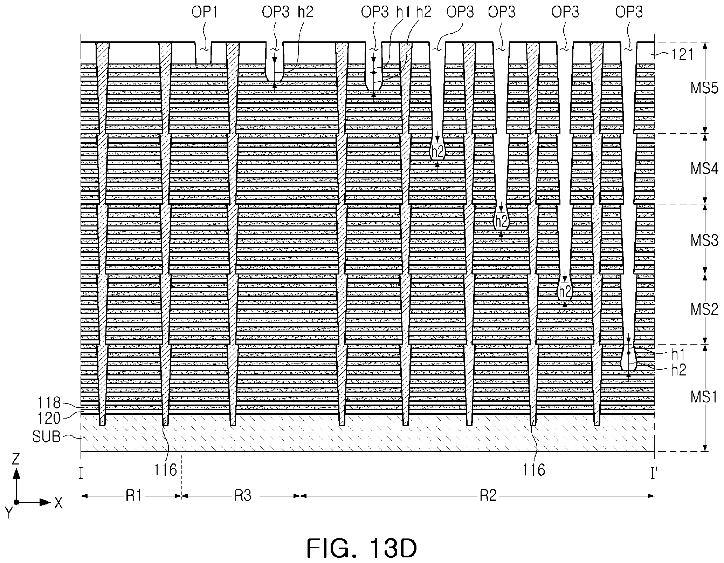

Referring to FIG. 13D, a third opening OP3 may be formed by etching the mold structures MS1-MS5 to penetrate two pairs of the sacrificial insulating layer 118, the sacrificial insulating layer 118 and the interlayer insulating layer 120 in a portion of the first opening OP1 or the second opening OP2.

The third opening OP3 may extend from the first opening OP1 or the second opening OP2 by a second depth h2. In this case, when the third opening OP3 is formed below the second opening OP2, the through-holes may have an increasing width downwardly by the same etching process which may be repeated, and a reduction portion having a width decreasing at the lowermost stage may be formed.

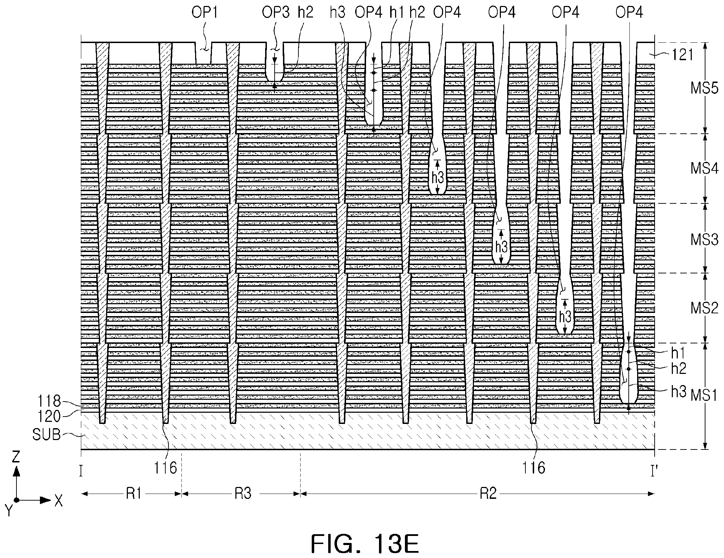

Referring to FIG. 13E, by etching the mold structures MS1-MS5, a fourth opening OP4 to penetrate four pairs of the sacrificial insulating layers 118, specifically, the sacrificial insulating layer 118 and the interlayer insulating layer 120, in a portion of the first to third openings OP1-OP3 which are opened.

The fourth opening OP4 may extend from the first opening OP1 to the third opening OP3 by a third depth h3. In this case, when the fourth opening OP4 is formed below the second opening OP2 or the third opening OP3, the through-holes may have an increasing width downwardly by the same etching process which may be repeated, and a reduction portion with a reduced width at the lowermost stage may be formed, such that contact holes having a shape forming the contact structures MCa, MCb, and MCc in FIG. 2A, respectively, may be formed.

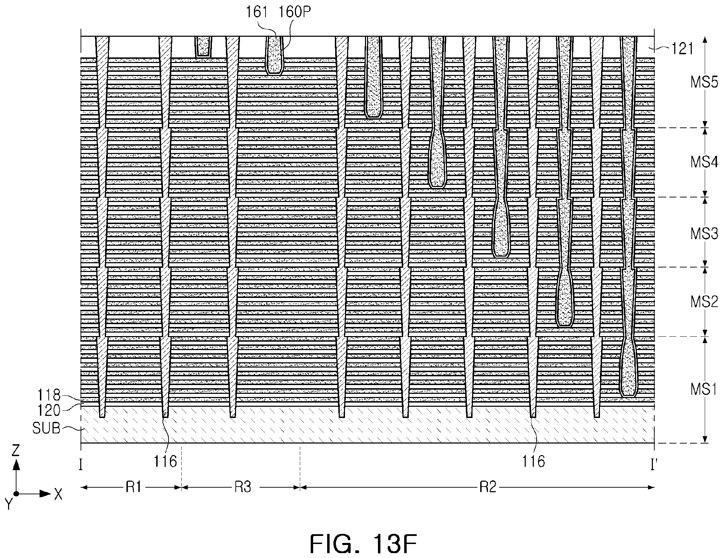

Referring to FIG. 13F, preliminary contact insulating layers 160P and contact sacrificial layers 161 may be formed on the first to fourth opening OP1-OP4.

The preliminary contact insulating layers 160P may be conformally formed to cover side walls and bottom surfaces of the first to fourth opening OP1-OP4. For example, the preliminary contact insulating layers 160P may be formed using an atomic layer deposition (ALD) process or a chemical vapor deposition (CVD) process.

The contact sacrificial layers 161 may be formed to fill the first to fourth opening OP1-OP4 on the preliminary contact insulating layers 160P. The contact sacrificial layers 161 may include a material different from a material of the preliminary contact insulating layers 160P, and may include, for example, carbon (C).

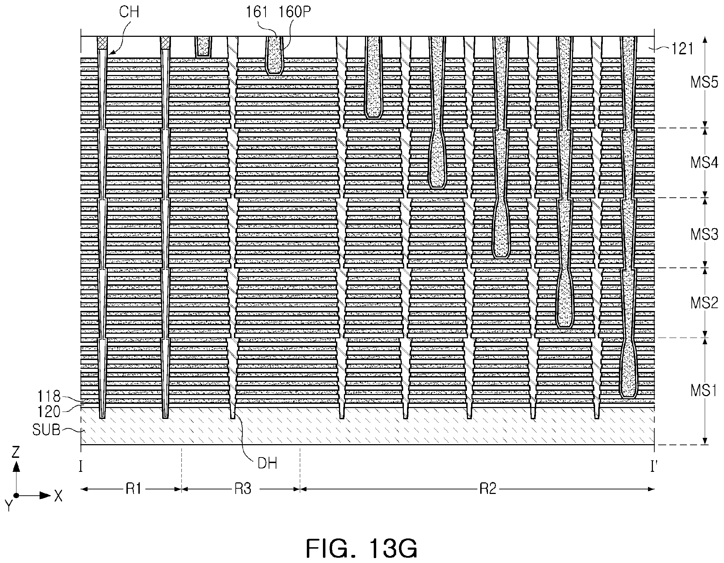

Referring to FIG. 13G, by removing a portion of the vertical sacrificial structures 116, channel structures CH may be formed.

A mask layer for exposing only a region corresponding to the channel structures CH in the memory region R1 may be formed, and by removing the exposed vertical sacrificial structures 116, channel holes may be formed. At least a portion of a channel dielectric layer 145, a channel layer 140, a channel buried insulating layer 147, and a channel pad 149 may be deposited in order within the channel holes, thereby forming the channel structures CH.

The channel dielectric layer 145 may be formed to have a uniform thickness using an ALD or CVD process. In this process, the entirety of or a portion of the channel dielectric layer 145 may be formed, and a portion extending vertically along the channel structures CH to the conductive layer 101 may be formed in this process. The channel layer 140 may be formed on the channel dielectric layer 145 within the channel holes. The channel buried insulating layer 147 may be formed to fill the channel holes and may be an insulating material. The channel pad 149 may be formed of a conductive material, for example, a polycrystalline silicon.

Also, a portion of the vertical sacrificial structures 116 may be removed and support structures DH may be formed.

A mask layer for exposing a region corresponding to the support structures DH in the string select region R3 and the extension region R2 may be formed, and by removing the exposed vertical sacrificial structures 116, dummy holes may be formed. A process of expanding the dummy holes by removing a portion of the mold structure around the dummy holes may be performed. The expanded dummy holes may be filled with an insulating material, thereby forming the support structures DH.

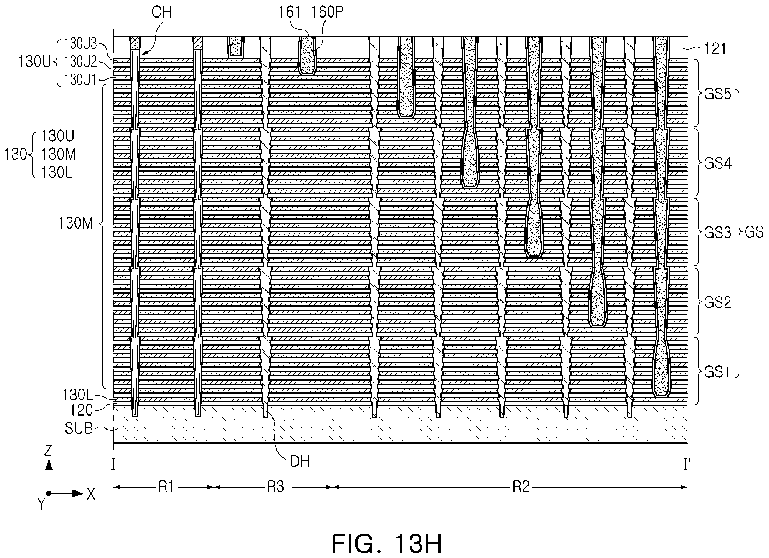

Referring to FIG. 13H, the sacrificial insulating layers 118 may be removed and the gate electrodes 130 may be formed.

An isolation opening for opening a region corresponding to the isolation regions MS in FIG. 1 and FIG. 2D may be formed. The isolation opening may be formed by forming a plurality of vertical holes in a region in which the isolation regions MS are formed, and a plurality of vertical holes may be formed by expanding the holes through a cleaning process, and connecting the holes with neighboring vertical holes. When the isolation opening is formed by expanding the plurality of vertical holes, the side surface of the isolation opening may continuously include convex curved surfaces, but some example embodiments thereof are not limited thereto.

The sacrificial insulating layers 118 exposed through the isolation opening may be removed. The sacrificial insulating layers 118 may be selectively removed, for example, using wet etching, with respect to the interlayer insulating layers 120, the channel structures CH, the support structures DH, and the preliminary contact insulating layers 160P.

The gate electrodes 130 may be formed by depositing a conductive material on regions from which the sacrificial insulating layers 118 are removed. The conductive material may include a metal, polycrystalline silicon, or a metal silicide material. In the gate electrodes 130, the diffusion barriers 131 may be formed (see FIG. 3A), and the conductive material may be deposited, thereby forming the gate electrodes 130. In some example embodiments, a portion of the channel dielectric layer 145 may be formed prior to forming the gate electrodes 130. Accordingly, a stack structure GS including first to fifth stack structures GS1-GS5 may be formed. After forming the gate electrodes 130, an insulating material may be deposited within the isolation opening, thereby forming the isolation regions MS extending in the X-direction as illustrated in FIG. 1.

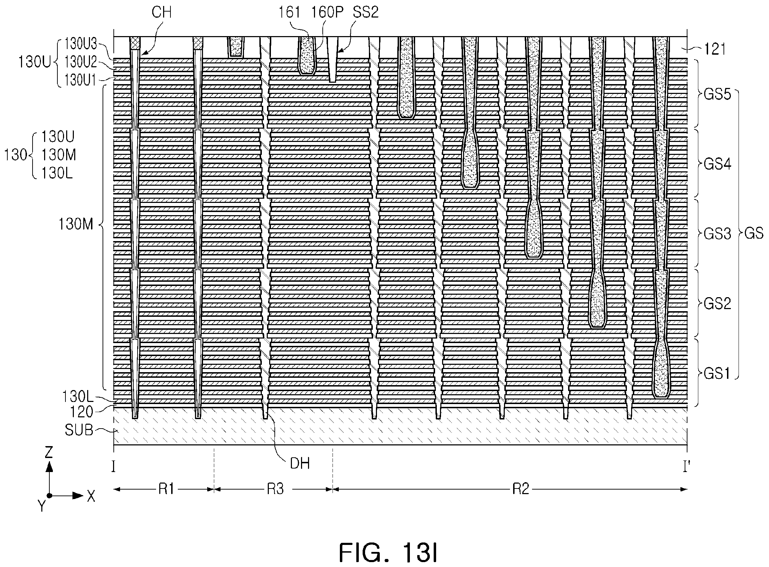

Referring to FIG. 13I, the first and second insulating regions SS1 and SS2 penetrating the upper gate electrodes 130U1-130U3 may be formed.

As illustrated in FIG. 1 and FIG. 2A and 2B, trenches for removing the upper gate electrodes 130U1-130U3 and the interlayer insulating layer 120 in regions corresponding to the first insulating regions SS1 and the second insulating regions SS2 may be formed.

Between two adjacent isolation regions MS, as horizontal trenches corresponding to the first insulating regions SS1, the first trenches may penetrate the first to third upper gate electrodes 130U1-130U3 from the upper portion of the uppermost interlayer insulating layer 121 to extend in the X-direction within the memory region R1 and the string select region R3, and the upper portion of the fifth stack structure GS5 may be selectively cut. The first trenches may be formed to extend while cutting a portion of the channel structures CH in the memory region R1.

Also, the second trenches may be formed in the region corresponding to the second insulating regions SS2. The second trenches may extend in the Y-direction to isolate the extension region R2 from the string select region R3, and may selectively cut the upper portion of the fifth stack structure GS5 to penetrate the first to third upper gate electrodes 130U1-130U3 from the upper portion of the uppermost interlayer insulating layer 121. Accordingly, the first and second trenches may not extend to the memory gate electrodes 130M corresponding to the wordline. An insulating material may be deposited in the first and second trenches, thereby forming the first and second insulating regions SS1 and SS2.

As illustrated in FIG. 13G, contact structures MCa, MCb, and MCc may be formed. Specifically, the contact sacrificial layers 161 may be selectively removed with respect to the preliminary contact insulating layers 160P, and a portion of the exposed preliminary contact insulating layers 160P may be removed, thereby forming the contact insulating layers 160.

That is, after the contact sacrificial layers 161 is removed, the exposed preliminary contact insulating layers 160P may be partially removed from the bottom surfaces. When the preliminary contact insulating layers 160P are removed, the exposed gate electrodes 130 may also be partially recessed from the upper surfaces. Accordingly, the contact insulating layers 160 disposed only on side walls of the first to fourth opening OP1-OP4 may be formed. The contact plugs MC1 and MC2 may be formed by depositing a conductive material within the first to fourth opening OP1-OP4. The contact plugs MC1, MC2 may be physically connected to the gate electrodes 130 allocated downwardly, respectively.

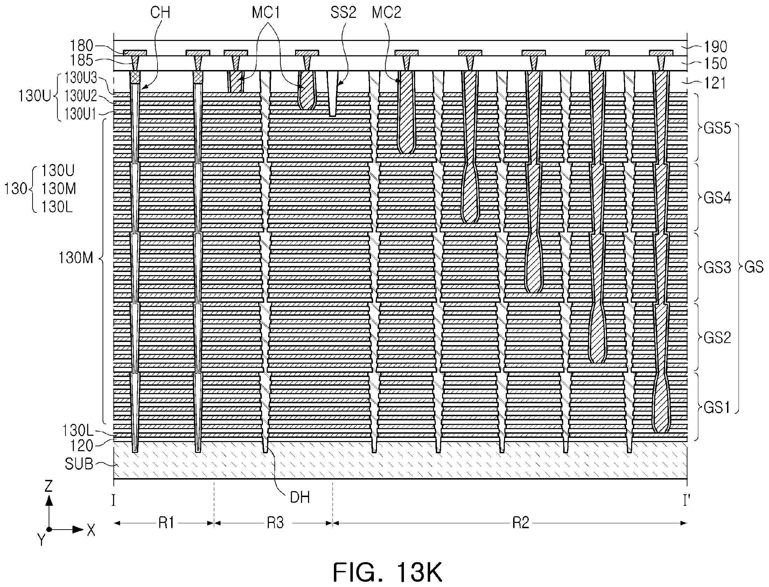

Referring to FIG. 13K, the upper interconnection structures 185 and 180 may be formed on the stack structures GS1-GS5.

After the cell region insulating layer 150 is formed, the studs 185 and the cell interconnection lines 180 may be formed.

The studs 185 may be formed by forming stud holes penetrating the cell region insulating layer 150 to expose the channel structures CH and the contact plugs MC1, MC2, and filling the stud holes with a conductive material. The cell interconnection lines 180 may be formed on the studs 185. An upper insulating layer 190 may be further formed on the cell interconnection lines 185, and a bonding structure for bonding with the second semiconductor structure in FIG. 11 may also be formed.

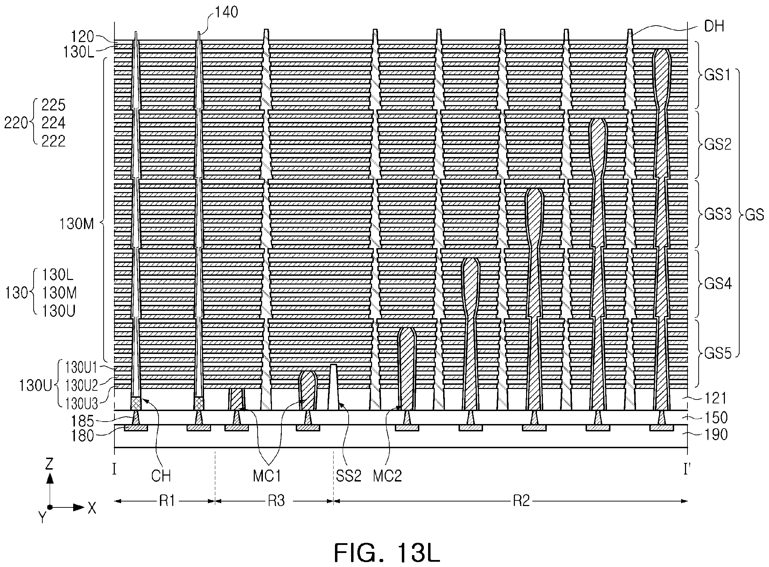

Referring to FIG. 13l, the base substrate SUB may be removed, and the channel layers 140 may be exposed.

By removing the base substrate SUB and a portion of the exposed channel dielectric layers 145 (see FIG. 3A), the channel layers 140 may be exposed.

Thereafter, referring to FIG. 2A, a conductive layer 101 connected to the channel layers 140 may be formed, and the semiconductor device 100 in FIG. 2A may be manufactured. In some example embodiments, the conductive layer 101 may be formed as a conformal layer along the upper stages of the channel structures CH and the upper stages of the support structures DH.

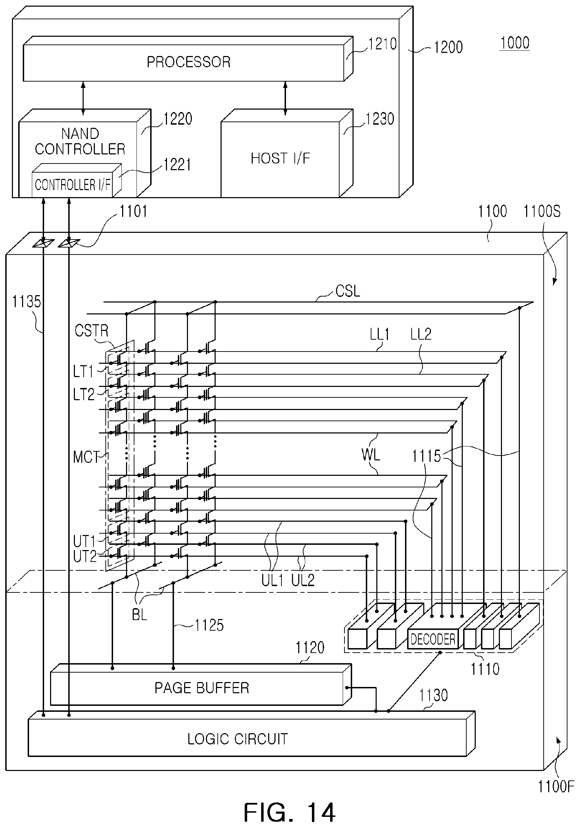

FIG. 14 is a diagram illustrating a data storage system including a semiconductor device according to some example embodiments.

Referring to FIG. 14, a data storage system 1000 may include a semiconductor device 1100 and a controller 1200 electrically connected to the semiconductor device 1100. The data storage system 1000 may be implemented as a storage device including one or a plurality of semiconductor devices 1100 or an electronic device including a storage device. For example, the data storage system 1000 may be implemented as a solid state drive device (SSD) including one or a plurality of semiconductor devices 1100, a universal serial bus (USB), a computing system, a medical device, or a communication device.

The semiconductor device 1100 may be implemented as a non-volatile memory device, such as, for example, the NAND flash memory device described in the aforementioned example embodiments with reference to FIGS. 1 to 12. The semiconductor device 1100 may include a first structure 1100F and a second structure 1100S on the first structure 1100F. In some example embodiments, the first structure 1100F may be disposed on the side of the second structure 1100S. The first structure 1100F may be a peripheral circuit structure including a decoder circuit 1110, a page buffer 1120, and a logic circuit 1130. The second structure 1100S may be a memory cell structure including a bitline BL, a common source line CSL, word lines WL, first and second gate upper lines UL1, UL2, first and second gate lower lines LL1, LL2, and memory cell strings CSTR between the bitline BL and the common source line CSL.

In the second structure 1100S, each of the memory cell strings CSTR may include lower transistors LT1 and LT2 adjacent to the common source line CSL, upper transistors UT1 and UT2 adjacent to the bitline BL, and a plurality of memory cell transistors MCT disposed between the lower transistors LT1 and LT2 and the upper transistors UT1 and UT2. The number of the lower transistors LT1 and LT2 and the number of the upper transistors UT1 and UT2 may be varied in some example embodiments.

In some example embodiments, the upper transistors UT1 and UT2 may include a string select transistor, and the lower transistors LT1 and LT2 may include a ground select transistor. The gate lower lines LL1 and LL2 may be configured as gate electrodes of the lower transistors LT1 and LT2, respectively. The word lines WL may be configured as gate electrodes of the memory cell transistors MCT, and the gate upper lines UL1 and UL2 may be configured as gate electrodes of the upper transistors UT1 and UT2, respectively.

In some example embodiments, the lower transistors LT1, LT2 may include a lower erase control transistor LT1 and a ground select transistor LT2 connected to each other in series. The upper transistors UT1, UT2 may include a string select transistor UT1 and an upper erase control transistor UT2 connected to each other in series. At least one of the lower erase control transistor LT1 and the upper erase control transistor UT2 may be used for an erase operation of erasing data stored in the memory cell transistors MCT by using GIDL phenomenon.

The common source line CSL, the first and second gate lower lines LL1, LL2, word lines WL, and the first and second gate upper lines UL1, UL2 may be electrically connected to the decoder circuit 1110 via the first connection wires 1115 extending from within the first structure 1100F to the second structure 1100S. The bit lines BL may be electrically connected to the page buffer 1120 via the second connection wires 1125 extending from within the first structure 1100F to the second structure 1100S.

In the first structure 1100F, the decoder circuit 1110 and the page buffer 1120 may perform a control operation on at least one selected memory cell transistor among the plurality of memory cell transistors MCT. The decoder circuit 1110 and the page buffer 1120 may be controlled by the logic circuit 1130. The semiconductor device 1100 may communicate with the controller 1200 through input/output pads 1101 electrically connected to the logic circuit 1130. The input/output pads 1101 may be electrically connected to the logic circuit 1130 through the input/output connection wiring 1135 extending from the first structure 1100F to the second structure 1100S.

The controller 1200 may include a processor 1210, a NAND controller 1220, and a host interface 1230. In some example embodiments, the data storage system 1000 may include a plurality of semiconductor devices 1100, and in this case, the controller 1200 may control the plurality of semiconductor devices 1100.

The processor 1210 may control overall operation of the data storage system 1000 including the controller 1200. The processor 1210 may operate according to a predetermined or alternatively desired firmware, and may access the semiconductor device 1100 by controlling the NAND controller 1220. The NAND controller 1220 may include a controller interface 1221 processing communication with the semiconductor device 1100. Through the controller interface 1221, a control command for controlling the semiconductor device 1100, data to be written to the memory cell transistors MCT of the semiconductor device 1100, and data to be read from the memory cell transistors MCT of the semiconductor device 1100 may be transmitted. The host interface 1230 may provide a communication function between the data storage system 1000 and an external host. When a control command from an external host is received through the host interface 1230, the processor 1210 may control the semiconductor device 1100 in response to the control command.

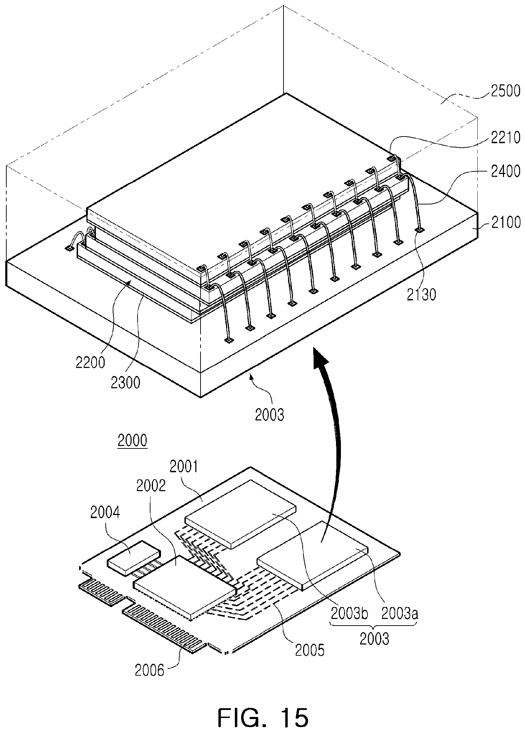

FIG. 15 is a perspective diagram illustrating a data storage system including a semiconductor device according to some example embodiments.

Referring to FIG. 15 a data storage system 2000 in some example embodiments may include a main board 2001, a controller 2002 mounted on the main board 2001, one or more semiconductor packages 2003, and a DRAM 2004. The semiconductor package 2003 and the DRAM 2004 may be connected to the controller 2002 by interconnection patterns 2005 formed on the main board 2001.

The main board 2001 may include a connector 2006 including a plurality of pins coupled to an external host. The number and arrangement of the plurality of pins in the connector 2006 may be varied depending on a communication interface between the data storage system 2000 and the external host. In some example embodiments, the data storage system 2000 may communicate with an external host according to one of interfaces from among universal serial bus (USB), peripheral component interconnect express (PCI-Express), serial advanced technology attachment (SATA), M-Phy for universal flash storage (UFS). In some example embodiments, the data storage system 2000 may operate by power supplied from an external host through the connector 2006. The data storage system 2000 may further include a power management integrated circuit (PMIC) for distributing power supplied from the external host to the controller 2002 and the semiconductor package 2003.

The controller 2002 may write data to or may read data from the semiconductor package 2003, and may improve an operating speed of the data storage system 2000.

The DRAM 2004 may be configured as a buffer memory for alleviating a difference in speeds between the semiconductor package 2003, which is a data storage space, and an external host. The DRAM 2004 included in the data storage system 2000 may operate as a cache memory, and may provide a space for temporarily storing data in a control operation for the semiconductor package 2003. When the data storage system 2000 may include the DRAM 2004, the controller 2002 may further include a DRAM controller for controlling the DRAM 2004 in addition to the NAND controller for controlling the semiconductor package 2003.

The semiconductor package 2003 may include first and second semiconductor packages 2003a and 2003b spaced apart from each other. Each of the first and second semiconductor packages 2003a and 2003b may be configured as a semiconductor package including a plurality of semiconductor chips 2200. Each of the first and second semiconductor packages 2003a and 2003b may include a package substrate 2100, semiconductor chips 2200 on the package substrate 2100, adhesive layers 2300 arranged on a lower surface of each of the semiconductor chips 2200, a connection structure 2400 electrically connecting the semiconductor chips 2200 to the package substrate 2100, and a molding layer 2500 covering the semiconductor chips 2200 and the connection structure 2400 on the package substrate 2100.

The package substrate 2100 may be configured as a printed circuit board including package upper pads 2130. Each of the semiconductor chips 2200 may include an input/output pad 2210. The input/output pad 2210 may correspond to the input/output pad 1101 in FIG. 14. Each of the semiconductor chips 2200 may include a semiconductor device as described above with reference to FIGS. 1 to 11.

In some example embodiments, the connection structure 2400 may be configured as a bonding wire electrically connecting the input/output pad 2210 to the upper package pads 2130. Accordingly, in each of the first and second semiconductor packages 2003a and 2003b, the semiconductor chips 2200 may be electrically connected to each other by a bonding wire method, and may be electrically connected to the package upper pads 2130 of the package substrate 2100. In some example embodiments, in each of the first and second semiconductor packages 2003a and 2003b, the semiconductor chips 2200 may be electrically connected to each other by a connection structure including a through-electrode (TSV) instead of the connection structure 2400 of a bonding wire method.

In some example embodiments, the controller 2002 and the semiconductor chips 2200 may be included in a single package. In some example embodiments, the controller 2002 and the semiconductor chips 2200 may be mounted on an interposer substrate different from the main board 2001, and the controller 2002 and the semiconductor chips 2200 may be connected to each other by interconnection formed on the interposer substrate.

Any or all of the elements described with reference to the figures may communicate with any or all other elements described with reference to the respective figures. For example, any element may engage in one-way and/or two-way and/or broadcast communication with any or all other elements, to transfer and/or exchange and/or receive information such as but not limited to data and/or commands, in a manner such as in a serial and/or parallel manner, via a bus such as a wireless and/or a wired bus (not illustrated). The information may be in encoded various formats, such as in an analog format and/or in a digital format.

Any of the elements and/or functional blocks disclosed above may include or be implemented in processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc. The processing circuitry may include electrical components such as at least one of transistors, resistors, capacitors, etc. The processing circuitry may include electrical components such as logic gates including at least one of AND gates, OR gates, NAND gates, NOT gates, etc.

According to some of the aforementioned example embodiments, contact structures in contact with the contact regions of the gate electrodes may be formed by the process of forming a contact structure without a step process for forming the contact regions of the gate electrodes in a step shape. In this case, in a semiconductor device having a stack structure having multiple stages, contact structures having a bent portion at the same level as the bent portion of the channel structure corresponding to each stage may be formed. That is, in the process for forming channel holes of the channel structure, the contact holes of the contact structure may be formed simultaneously, such that the depth of the contact hole etched at one time may be reduced (for example, significantly). Accordingly, defects such as short circuits due to expansion of the contact holes due to the formation of a relatively deep contact hole may be prevented or reduced in likelihood.

Accordingly, as the process is simplified and the position of the contact hole is specified, a semiconductor device having improved reliability and a data storage system including the same may be provided.

Embodiments are set out in the following Clauses:
Clause 1. A semiconductor device, comprising:
   a conductive layer;
   a plurality of stack structures, each stack structure of the plurality of stack structures including a plurality of gate electrodes stacked in order in a first direction perpendicular to an upper surface of the conductive layer, the plurality of stack structures stacked in order in the first direction in a first region and in a second region neighboring the first region;
   a channel structure including a plurality of channel portions penetrating the plurality of stack structures, respectively and the plurality of channel portions connected to each other in the first direction in the first region;
   a plurality of first-type contact structures penetrating at least one of the gate electrodes of an uppermost stack structure among the plurality of stack structures, the plurality of first-type contact structures extending to different lengths and electrically connected to the gate electrodes of the uppermost stack structure, respectively, in the second region;
   a plurality of second-type contact structures completely penetrating at least one of the plurality of stack structures from an upper portion of the uppermost stack structure, the plurality of second-type contact structures extending to different lengths, and electrically connected to uppermost gate electrodes of the stack structures below the uppermost stack structure, respectively, in the second region; and
   a plurality of third-type contact structures, each third-type contact structure including a first portion completely penetrating at least one of the plurality of stack structures from the upper portion of the uppermost stack structure, and a second portion extending from a lower portion of the first portion to a different length, penetrating at least one of the gate electrodes and electrically connected to an allocated gate electrode in the second region,
   wherein a boundary surface between the first portion and the second portion of each of the third-type contact structures is at a same level as a boundary surface between the plurality of channel portions of the channel structure.
Clause 2. The semiconductor device of Clause 1, wherein
   each of the plurality of channel portions of the channel structure includes an upper surface, a lower surface having a width smaller than a width of the upper surface, and an inclined side surface between the upper surface and the lower surface, and
   the channel structure includes bent portions such that the width of the lower surface of each channel portion located above is smaller than the width of the upper surface of the channel portion located below on boundary surfaces between the channel portions.
Clause 3. The semiconductor device of Clause 1 or Clause 2, wherein, in each of the third-type contact structures, the first portion includes at least one sub-part completely penetrating one of the plurality of stack structures.
Clause 4. The semiconductor device of Clause 3, wherein
   each of the sub-parts includes an upper surface, a lower surface having a width smaller than a width of the upper surface, and an inclined side surface between the upper surface and the lower surface, and
   an upper surface of the second portion has a same width as the width of the lower surface of a lowermost sub-part among the sub-parts of the first portion.
Clause 5. The semiconductor device of any preceding Clause, wherein the first portion of the third-type contact structures has a shape the same as or corresponding to at least one of the second-type contact structures.
Clause 6. The semiconductor device of any preceding Clause, wherein the third-type contact structures are symmetrical with respect to a central line of a width of an upper surface.
Clause 7. The semiconductor device of any preceding Clause, wherein a side surface of the second portion of the third-type contact structures includes at least one inflection point such that a slope changes.
Clause 8. The semiconductor device of any preceding Clause, wherein
   the first-type contact structures include a region having a width that increases from an upper portion to a lower portion, and
   the second portion of the third-type contact structures includes a region having a width that increases from an upper portion to a lower portion.
Clause 9. The semiconductor device of any preceding Clause, wherein
   the first-type contact structures include a region decreasing in width downwards, and
   the second portion of the third-type contact structures includes a region increasing in width downwards and a region decreasing in width downwards.
Clause 10. The semiconductor device of any preceding Clause, wherein
   each of the first-type contact structures include a region having a constant width, and
   the second portion of each of the third-type contact structures includes a region having a constant width.
Clause 11. The semiconductor device of any preceding Clause, wherein the second portion of each of the third-type contact structures is asymmetrical with respect to a central line of a width of an upper surface.
Clause 12. The semiconductor device of any preceding Clause, wherein each of the first-type, the second-type, and the third-type contact structures includes,
   a contact plug including a plug conductive layer and a contact barrier layer on a side surface and a lower surface of the plug conductive layer; and
   a side insulating layer surrounding the side surface of the contact plug,
   wherein a lower surface of the contact barrier layer is in contact with an upper surface of one of the gate electrodes.
Clause 13. The semiconductor device of any preceding Clause, further comprising:
   an interlayer insulating layers stacked alternately with the gate electrodes;
   an uppermost interlayer insulating layer on an uppermost gate electrode; and
   a fourth type contact structure penetrating the uppermost interlayer insulating layer and in contact with an upper surface of the uppermost gate electrode.
Clause 14. A semiconductor device, comprising:
   a conductive layer;
   a plurality of stack structures, each stack structure of the plurality of stack structures including gate electrodes stacked in order in a first direction perpendicular to an upper surface of the conductive layer, the plurality of stack structures stacked in order in the first direction in a first region and a second region neighboring the first region;
   a channel structure penetrating the plurality of stack structures and extending in the first direction in the first region; and
   contact structures each including a first portion completely penetrating at least one of the plurality of stack structures from an upper portion of an uppermost stack structure, and a second portion extending from a lower portion of the first portion to a different length, penetrating at least one of the gate electrodes and in contact with an allocated gate electrode, wherein
   the first portion includes at least one sub-part completely penetrating one of the stack structures,
   a width of an upper surface each of the at least one sub-part is greater than a width of a lower surface of the at least one sub-part, and the at least one sub-part includes a continuously inclined side surface between the upper surface and the lower surface, and
   widths of a lower surface of the first portion and an upper surface of the second portion are the same.
Clause 15. The semiconductor device of Clause 14, wherein, in response to the first portion including at least two sub-parts, the first portion includes a bent portion such that a width of the upper surface of the sub-part located below is greater than a width of the lower surface of the sub-part located above at a boundary surface between the sub-parts.
Clause 16. The semiconductor device of Clause 14 or Clause 15, wherein
   the at least one sub-part of the first portion has a width decreasing toward the conductive layer, and
   the second portion includes a region having a width increasing toward the conductive layer.
Clause 17. The semiconductor device of any of Clauses 14-16, wherein the second portion includes a reduction portion of such that a width decreases in a portion close to a lower surface.
Clause 18. The semiconductor device of any of Clauses 14-17, wherein the contact structures include contact structures such that lengths of the first portions are different and lengths of the second portions are the same.
Clause 19. A data storage system, comprising:
   a semiconductor storage device including a first semiconductor structure including circuit elements, a second semiconductor structure on one surface of the first semiconductor structure, an input/output pad electrically connected to the circuit elements; and
   a controller electrically connected to the semiconductor storage device through the input/output pad and controlling the semiconductor storage device,
   wherein the second semiconductor structure includes,
   a conductive layer;
   a plurality of stack structures, each stack structure of the plurality of stack structures including gate electrodes stacked in order in a first direction perpendicular to an upper surface of the conductive layer, the plurality of stack structures stacked in order in the first direction in a first region and a second region neighboring the first region;
   a channel structure penetrating the plurality of stack structures and extending in the first direction in the first region; and
   contact structures including a first portion completely penetrating at least one stack structure of the plurality of stack structures from an upper portion of an uppermost stack structure, and a second portion extending from a lower portion of the first portion to a different length, penetrating at least one of the gate electrodes and in contact with an allocated gate electrode in the second region, wherein
   the first portion includes at least one sub-part completely penetrating one of the stack structures,
   a width of an upper surface of each of the at least one sub-part is greater than a width of a lower surface of the at least one sub-part, and the at least one sub-part includes an inclined side surface between the upper surface and the lower surface continuously, and
   widths of a lower surface of the first portion and an upper surface of the second portion are the same.
Clause 20. The data storage system of Clause 19, wherein
   the channel structure includes a plurality of channel portions penetrating the plurality of stack structures, respectively, and the plurality of channel portions are connected to each other in the first direction, and
   a boundary surface between the first portion and the second portion of the contact structures is at a same level as one of boundary surfaces between the plurality of channel portions of the channel structure.

While some example embodiments have been illustrated and described above, it will be configured as apparent to those skilled in the art that modifications and variations could be made without departing from the scope of the present disclosure as defined by the appended claims.

## Claims

1. A semiconductor device, comprising:
a conductive layer;
a plurality of stack structures, each stack structure of the plurality of stack structures including a plurality of gate electrodes stacked in order in a first direction perpendicular to an upper surface of the conductive layer, the plurality of stack structures stacked in order in the first direction in a first region and in a second region neighboring the first region;
a channel structure including a plurality of channel portions penetrating the plurality of stack structures, respectively and the plurality of channel portions connected to each other in the first direction in the first region;
a plurality of first-type contact structures penetrating at least one of the gate electrodes of an uppermost stack structure among the plurality of stack structures, the plurality of first-type contact structures extending to different lengths and electrically connected to the gate electrodes of the uppermost stack structure, respectively, in the second region;
a plurality of second-type contact structures completely penetrating at least one of the plurality of stack structures from an upper portion of the uppermost stack structure, the plurality of second-type contact structures extending to different lengths, and electrically connected to uppermost gate electrodes of the stack structures below the uppermost stack structure, respectively, in the second region; and
a plurality of third-type contact structures, each third-type contact structure including a first portion completely penetrating at least one of the plurality of stack structures from the upper portion of the uppermost stack structure, and a second portion extending from a lower portion of the first portion to a different length, penetrating at least one of the gate electrodes and electrically connected to an allocated gate electrode in the second region,
wherein a boundary surface between the first portion and the second portion of each of the third-type contact structures is at a same level as a boundary surface between the plurality of channel portions of the channel structure.

2. The semiconductor device of claim 1, wherein
each of the plurality of channel portions of the channel structure includes an upper surface, a lower surface having a width smaller than a width of the upper surface, and an inclined side surface between the upper surface and the lower surface, and
the channel structure includes bent portions such that the width of the lower surface of each channel portion located above is smaller than the width of the upper surface of the channel portion located below on boundary surfaces between the channel portions.

3. The semiconductor device of claim 1 or claim 2, wherein, in each of the third-type contact structures, the first portion includes at least one sub-part completely penetrating one of the plurality of stack structures.

4. The semiconductor device of claim 3, wherein
each of the sub-parts includes an upper surface, a lower surface having a width smaller than a width of the upper surface, and an inclined side surface between the upper surface and the lower surface, and
an upper surface of the second portion has a same width as the width of the lower surface of a lowermost sub-part among the sub-parts of the first portion.

5. The semiconductor device of any preceding claim, wherein the first portion of the third-type contact structures has a shape the same as or corresponding to at least one of the second-type contact structures.

6. The semiconductor device of any preceding claim, wherein the third-type contact structures are symmetrical with respect to a central line of a width of an upper surface.

7. The semiconductor device of any preceding claim, wherein a side surface of the second portion of the third-type contact structures includes at least one inflection point such that a slope changes.

8. The semiconductor device of any preceding claim, wherein
the first-type contact structures include a region having a width that increases from an upper portion to a lower portion, and
the second portion of the third-type contact structures includes a region having a width that increases from an upper portion to a lower portion.

9. The semiconductor device of any preceding claim, further comprising:
interlayer insulating layers stacked alternately with the gate electrodes;
an uppermost interlayer insulating layer on an uppermost gate electrode; and
a fourth type contact structure penetrating the uppermost interlayer insulating layer and in contact with an upper surface of the uppermost gate electrode.

10. The semiconductor device of any preceding claim, wherein
the first-type contact structures include a region decreasing in width downwards, and
the second portion of the third-type contact structures includes a region increasing in width downwards and a region decreasing in width downwards.

11. The semiconductor device of any preceding claim, wherein
each of the first-type contact structures include a region having a constant width, and
the second portion of each of the third-type contact structures includes a region having a constant width.

12. The semiconductor device of any preceding claim, wherein the second portion of each of the third-type contact structures is asymmetrical with respect to a central line of a width of an upper surface.

13. The semiconductor device of any preceding claim, wherein each of the first-type, the second-type, and the third-type contact structures includes,
a contact plug including a plug conductive layer and a contact barrier layer on a side surface and a lower surface of the plug conductive layer; and
a side insulating layer surrounding the side surface of the contact plug,
wherein a lower surface of the contact barrier layer is in contact with an upper surface of one of the gate electrodes.

14. The semiconductor device of any preceding claim, wherein the second portion of one of the third-type contact structures corresponds to a part of one of the first-type structures.

15. A data storage system, comprising:
a semiconductor storage device including a first semiconductor structure including circuit elements, a second semiconductor structure on one surface of the first semiconductor structure, an input/output pad electrically connected to the circuit elements; and
a controller electrically connected to the semiconductor storage device through the input/output pad and controlling the semiconductor storage device,
wherein the second semiconductor structure comprises a semiconductor device according to any preceding claim.
